**Europäisches Patentamt**

**European Patent Office**

**Office européen des brevets**

(11) Veröffentlichungsnummer: **0 155 974**
**B1**

(12) **EUROPÄISCHE PATENTSCHRIFT**

(45) Veröffentlichungstag der Patentschrift:
**01.03.89**

(51) Int. Cl.⁴: **G 01 D 5/245, H 03 M 1/22**

(21) Anmeldenummer: **84102956.4**

(22) Anmeldetag: **17.03.84**

(54) Verfahren und Schaltungsanordnung zur Beeinflussung der Quad-Impulse von inkrementalen Messsystemen.

(43) Veröffentlichungstag der Anmeldung:
**02.10.85 Patentblatt 85/40**

(45) Bekanntmachung des Hinweises auf die Patenterteilung:
**01.03.89 Patentblatt 89/9**

(84) Benannte Vertragsstaaten:
**BE CH DE FR GB IT LI SE**

(56) Entgegenhaltungen:
**EP-A- 0 076 861**
**DE-A- 3 106 429**
**GB-A- 2 061 523**

(73) Patentinhaber: **Schiess Aktiengesellschaft Geschäftsbereich Schiess-Froriep, Schiess Strasse 61, D-4000 Düsseldorf 11 (DE)**

(72) Erfinder: **Russ, Peter, Dipl.-Ing., Schumannstrasse 18, D-4019 Monheim (DE)**

(74) Vertreter: **Allgeier, Kurt et al, Friedrichstrasse 24, D-7888 Rheinfelden (DE)**

**Beschreibung**

Die Erfindung bezieht sich auf ein Verfahren zur Beeinflussung der Quad-Impulse von inkrementalen Meßsystemen zum Erfassen der Bewegungen ein- oder mehrachsig zueinander verschieb- und/oder verdrehbarer Elemente an maschinellen Vorrichtungen, insbes. Werkzeugmaschinen. bei dem die Impulsfolgen der Inkrementalgeber zur Korrektur von Positionsfehlern oder zur kontrollierten Überlagerung von Zusatzbewegungen mit einer Frequenz abgetastet werden, die höher als die der max. auftretenden Bewegungsgeschwindigkeit entsprechende Frequenz liegt, und bei welchem das Resultat der Bewegungserfassung durch meßgeberfremde Zusatzimpulse veränderbar ist. Verfahrensweisen und Schaltungen dieser Art sind bekannt, jedoch nicht druckschriftlich belegbar.

Eine bekannte Schaltungsanordnung zum elektronischen Koppeln mindestens zweier Inkrementalgeber, die abhängig von der Längsbewegung zweier Gegenstände relativ zueinander bzw. zu einem festen Punkt Impulse abgeben, deren Anzahl dem jeweiligen Bewegungsausmaß entspricht, insbesondere für Verstelleinrichtungen an Werkzeug-Meßmaschinen oder dergl., besteht darin, daß die Impulsfolgen der beiden Inkrementalgeber von einem Taktgeber abwechselnd mit einer Frequenz getaktet werden, die höher als die der maximalen Bewegungsgeschwindigkeit der Gegenstände entsprechenden Frequenz ist, und daß eine Summiervorrichtung oder ähnlichen Auswertevorrichtung zugeführt wird (DE-OS 3 106 429).

Die bekannte Schaltungsanordnung ist insbesondere zur Erfassung zweier überlagerter Bewegungen über getrennte Meßwertgeber und deren additive Darstellung in einer einzigen Anzeige geeignet: als Anwendungsfall kommt die Erfassung der Position eines beweglichen Meßpunktes bezüglich einer Basis in Betracht, die ihrerseits relativ zur Position eines Festpunktes veränderlich ist.

Demgegenüber liegt dem erfindungsgemäßen Verfahren die Aufgabe zugrunde, ein Verfahren zur Beeinflussung der Quad-Impulse von inkrementalen Meßsystemen zum Erfassen der Bewegungen ein- oder mehrachsig zueinander verschieb- und/oder verdrehbarer Elemente an maschinellen Vorrichtungen zu schaffen, das es ermöglicht, meßgeberfremde Zusatzimpulse positiven oder negativen Sinnes in die Geberimpulsfolgen einzumischen, ohne daß die Impulsfolgefrequenz der resultierenden Quad-Impulse über die Abtastrate der Geberimpulse hinausgeht. Ein derartiges Verfahren ist beispielsweise dazu geeignet, in Lagerregelkreisen einer Grundbewegung eine extern generierte Zusatzbewegung zu überlagern. Zur Lösung dieser Aufgabe ist die bekannte Schaltungsanordnung nicht geeignet, weil der dort angeordnete zweite Geber, der als externe Impulsquelle in Betracht käme, völlig unabhängig vom ersten Geber arbeitet, und daher die Folgefrequenz zwischen zwei «AUF», zwei «AB» oder einem «AB» und einem «AUF»-Impuls am Impulsrückformer so hoch werden kann, wie die Abtastrate. Daraus ergibt sich, daß diese Abtastrate nicht höher liegen darf als die max. verarbeitbare Frequenz der vom Impulsrückformer anzusteuernden Auswerte-Einheit. Eine Unterabtastung der Geber wird auf Grund der wechselseitigen Abtastung demnach nur dann vermieden, wenn deren zulässige max. Pulsfolgefrequenz unterhalb der halben Abtastfrequenz bleibt, was zur Folge hat, daß die höchstmögliche Geschwindigkeitsausnutzung des Positionier- bzw. Verfahrsystems auf die Hälfte reduziert ist.

Um diesen Nachteil zu vermeiden, wird für ein eingangs genanntes Verfahren in Anspruch 1 vorgeschlagen, daß beim Abtasten der Geberimpulsreihen A und B mit einer über der durch Exklusiv-Oder-Verknüpfung entstehenden Pegelwechselfrequenz liegenden Abtastrate die am Ausgang des Abtasters im Rhythmus der Differenz zwischen beiden Frequenzen auftretenden Impulswechselpausen zum Einfügen geberfremder Zusatzsignale ausgenutzt werden, wobei die Impulswechselpausen so rechtzeitig erfaßt werden, daß ein kontrollierter, in sich abgeschlossener Impulseinfügungsvorgang eingeleitet wird, der aus einem zusätzlich initiierten Signalpegelwechsel bei einer der beiden abgetasteten, eine Phasenkorrektur aufweisenden Geberimpulsreihen A' und B' besteht.

Dies ermöglicht, daß bei einer einmal festgelegten Abtastrate, die entsprechend den Spezifikationen der anzusteuernden Auswerte-Einheit ausgelegt ist, die mögliche Folgefrequenz der zusätzlichen Signalwechselimpulse positiven oder negativen Sinnes in dem Maße steigt, wie die aktuelle Impulsfolgefrequenz des Meßwertgebers bei 4-fach-Auswertung sinkt, und daß insbesondere auch noch bei einer wenig unterhalb der Abtastrate liegenden Geberfrequenz ein Einspeisen von Zusatzimpulsen im Rhythmus der Differenz beider Frequenzen möglich ist, ohne daß dabei die Impulsfolgefrequenz der resultierenden Quad-Impulse die Abtastrate der Geberimpulse überschreitet.

Diese Funktionsweise hat gegenüber dem Stand der Technik den Vorteil, daß im Falle des Nichteinfügens von Zusatzimpulsen die maximal mögliche Betriebsfrequenz des Meß- oder Positionierkreises voll ausgenutzt werden kann und nur um die Frequenz reduziert werden muß, mit der das Einfügen von Zusatzimpulsen erfolgt.

Um diesen Gedanken zu verwirklichen, wird weiterhin vorgeschlagen, daß durch Vorabtastung der Geberphasen A' und B', mittels gegenüber den Abtastimpulsen zeitversetzter Vorabtastimpulse, im Falle des Auftretens eines Pegelwechsels bei A oder B, ein Unterbrechungssignal so rechtzeitig erzeugt wird, daß ein eingeleiteter und zum nächsten Abtastzeitpunkt vorgesehener zusätzlicher Signalpegelwechsel bei einer der beiden am Ausgang des Abtasters vorliegenden abgetasteten Geberphasen A' und B' solange zurückgehalten wird, bis er in die nächstfolgende Impulswechselpause eingefügt wird.

Zur Durchführung dieses Einfügens wird vorgeschlagen. daß zusätzlich initiierte Signalpegelwechsel bei jeweils einer der abgetasteten Geberphasen A' und B' durch Änderung der Zuordnung zwischen diesen einerseits und den das Resultat dieses Impulseinfügungsvorganges repräsentierenden. einer nachfolgenden Auswerteeinheit zugeführten Signalphasen A''' und B''' andererseits, in Abhängigkeit des Richtungssinnes der Zusatzimpulse und der momentan bestehenden Zuordnung, gemäß nachstehendem Schema veranlaßt werden:

$$A''' \rightarrow \quad A' \quad B' \quad \overline{A'} \quad \overline{B'} \quad A' \quad B' \quad \overline{A'} \quad \overline{B'} \quad A'$$
$$B''' \rightarrow \quad B' \quad \overline{A'} \quad \overline{B'} \quad A' \quad B' \quad \overline{A'} \quad \overline{B'} \quad A' \quad B'$$

$$\rightarrow \rightarrow \rightarrow \rightarrow \rightarrow \rightarrow \rightarrow \rightarrow \rightarrow \rightarrow \rightarrow \rightarrow \rightarrow$$

wobei ein Signalzuordnungswechsel in diesem Schema nach rechts eine linkssinnige Einfügung und umgekehrt bedeutet.

$$\leftarrow \leftarrow \leftarrow \leftarrow \leftarrow \leftarrow \leftarrow \leftarrow \leftarrow \leftarrow \leftarrow \leftarrow \leftarrow$$

Die nach dem Erfindungsgedanken verwendeten Quad-Impulse bestehen aus zwei Impulsreihen. deren zeitliches Verhalten zueinander dem der beiden binären Ausgänge eines 2-bit vor/rück Gray-Code-Zählers entsprechen. Dabei ergibt sich die zeitliche Abfolge der logischen Zustände der Zählerausgänge in Vorwärtszählrichtung wie folgt:

$$A''' \rightarrow \quad 0 \quad 1 \quad 1 \quad 0 \quad 0$$
$$B''' \rightarrow \quad 0 \quad 0 \quad 1 \quad 1 \quad 0$$

Und in Rückwärtszählrichtung:

$$A''' \rightarrow \quad 0 \quad 0 \quad 1 \quad 1 \quad 0$$
$$B''' \rightarrow \quad 0 \quad 1 \quad 1 \quad 0 \quad 0$$

Der Erfindungsgedanke ermöglicht es. die Geberimpulsreihen A und B mit einer festen Abtastrate abzutasten, die nur wenig höher liegt als die maximale Impulsfolgefrequenz bei 4-fach-Auswertung. bei welcher jede Änderung des logischen Zustandes sowohl von A wie von B als Zählimpuls wirkt. Es genügt dabei, daß die Abtastrate um ca. 15% höher liegt als die maximale Impulsfolgefrequenz; wenn diese beispielsweise bei 200 kHz liegt, so werden mit einer Abtastrate von ca. 230 kHz ausgezeichnete Ergebnisse erzielt. Dabei ist jedoch erforderlich, daß die nachfolgende Auswerte-Einheit, in der Regel eine CNC-Steuerung, so ausgelegt ist, daß sie Quad-Impulse von 230 kHz Pulsfolgefrequenz bei 4-fach-Auswertung – also der Abtastrate – verarbeiten kann.

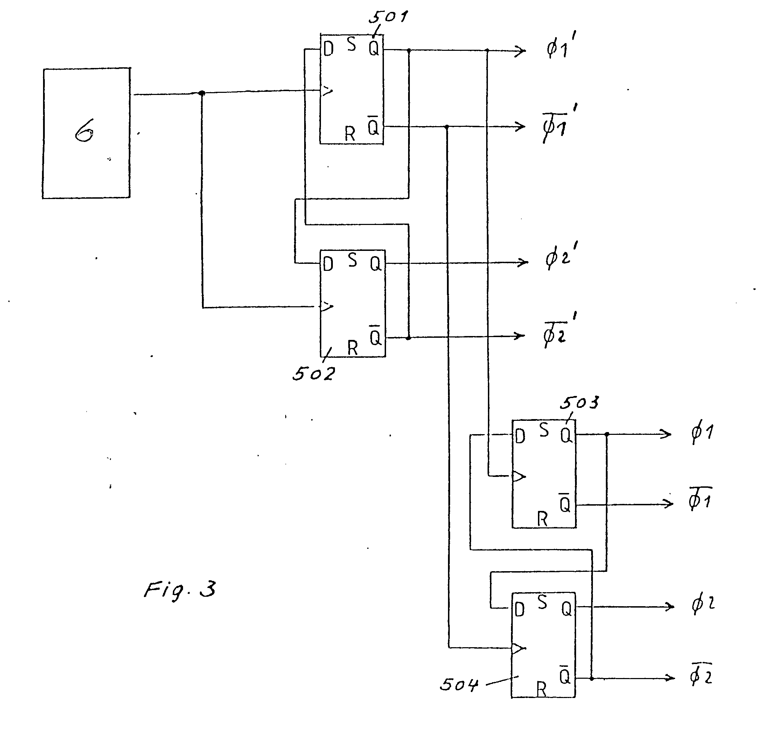

Das Resultat ist, daß im Rhythmus der Differenz von Pulsfolgefrequenz des Gebersignals und der Abtastrate, hier also ca. 30 kHz, Zeitpunkte im Abtastraster auftreten, zu denen kein Signalwechsel von A' oder B' erfolgt. Zu diesen Zeitpunkten können nur zusätzliche Signalwechsel von A' oder B' initiiert werden, ohne daß dabei die Impulsfolgefrequenz der resultierenden Quad-Impulse A''' und B''', gemäß Fig. 3. die Abtastrate der Geberimpulse überschreitet.

Die maximale Arbeitsfrequenz des inkrementalen Meßsystems braucht also trotz der Möglichkeit des Einmischens zusätzlicher rechts- oder linkssinniger Zählimpulse nicht reduziert zu werden, sofern diese nur unwesentlich niedriger liegen als die von der Auswerteeinheit maximal verarbeitbaren Pulsfolgefrequenz.

Bei dem erfindungsgemäßen Abtastverfahren ist auch der Fall vorgesehen, daß vor dem Einmischen der programmierten Simulations-Impulswechsel ein Signalwechsel bei den Geber-Impulsreihen A oder B auftritt; in diesem Fall ist der Abtast-Algorithmus derart eingerichtet, daß eine Unterbrechungsanforderung die Einmischung der Simulations-Impulswechsel unterbricht und zunächst für den darauffolgenden Abtastzeitpunkt die Zwangsführung des Gray-Code-Zählers durch A'' und B'' wieder herstellt. Dies erfordert, daß das Abtastverfahren, den Geberimpuls-Signalwechsel rechtzeitig erkennt.

Die Fähigkeit des erfindungsgemäßen Abtastverfahrens, einen Signalwechsel von A' oder B' zum nächstfolgenden Abtastzeitpunkt vorherzusagen, beruht auf seiner zweistufigen Arbeitsweise.

In der ersten Stufe wird eine Vorabtastung mit einer zeitlich versetzten, um den Faktor 2 höheren Abtastrate durchgeführt. Dies erhöht einerseits die Reaktionsgeschwindigkeit auf einen Gebersignalwechsel und andererseits die Störsicherheit, da mindestens zweimal pro Geber-Viertelperiode abgetastet wird.

Um einen störungsfreien Ablauf des erfindungsgemäßen Einmischens von Fremd-Signalwechseln sicherzustellen. ist es von grundsätzlicher Bedeutung, daß das Abtasten der Geberimpulsreihen von Störimpulsen freigehalten wird. Solche Störimpulse können von den verschiedensten Quellen ausgehen, wie diese insbesondere in Werkstattbetrieben mit hoher Konzentration von maschinellen Antrieben und deren Steuerungen vorkommen.

Mit diesen Schwierigkeiten muß unabhängig von der hier beanspruchten erfindungsgemäßen Lösung überall dort gerechnet werden, wo Digital-Impulsfolgen mittels einer Abtastfrequenz abgetastet werden und Störimpulse auftreten können. Daher wird als selbständiger Erfindungsvorschlag zur Störimpulsunterdrückung ein Verfahren vorgeschlagen, bei dem zum Erfassen der Bewegungen ein- oder mehrachsig zueinander verschieb-und/oder verdrehbarer Elemente an maschinellen Vorrichtungen, insbes. Werkzeugmaschinen, bei dem die Impulsfolgen der Inkrementalgeber mit einer Frequenz abgetastet werden, die höher als die der max. auftretenden Bewegungsgeschwindigkeit entsprechenden Frequenz liegt, und bei welchem das Resultat der Bewegungserfassung durch meßgeberfremde Zusatzimpulse veränderbar ist, wobei Eingangs-Signalwechsel 0 → 1 bzw. 1 → 0 von kürzerer Dauer als der Dauer der die Information enthaltenden Nutzsignalwechsel dadurch unterdrückt werden, daß deren Länge in einer sequenziell arbeitenden Logikanordnung über zwei zeitlich versetzte Taktphasen gemessen und in Abhängigkeit vom Meßergebnis unterdrückt oder weitergeleitet werden.

Die Weiterbildung dieses Verfahrens kann zwei Flip-Flops umfassen, deren Ausgänge über eine EX-OR-Verknüpfung dem D-Eingang eines der beiden mit einer der Taktphasen getriggerten Flip-Flops zugeführt werden, dessen Ausgang gleichzeitig über eine weitere EX-OR-Verknüpfung mit dem Eingangssignal dem Rücksetzeingang des anderen der beiden mit der zweiten Taktphase getriggerten Flip-Flops zugeführt wird, dessen D-Eingang einen stationären High-Pegel erhält, und wobei der Ausgang des erstgenannten Flip-Flops das Ausgangssignal darstellt.

Mit dieser Verfahrensweise ist es möglich, vor dem eigentlichen Abtasten der Geberimpulsreihen von beispielsweise 200 kHz mit einer Abtastfrequenz von 230 kHz einen Stör-Pegelwechsel der Gebersignale A, B und Z auszublenden, dessen Dauer kürzer ist als ca. 540 ns und damit als Störung zu interpretieren. Der Wert von 540 ns ergibt sich aus dem Abstand der Taktphasen $\overline{\emptyset\,1}$ und $\overline{\emptyset\,2}$.

Außerdem besteht ein weiterer wesentlicher, von der beanspruchten Lösung unabhängiger Gedanke in einer Referenzimpuls-Synchronisation in der Weise, daß bei der Verfahrensweise des gattungsgemäßen Abtastens von Impulsfolgen A und B von Inkrementalgebern mittels einer Abtastfrequenz in Verbindung mit einer Referenzimpulsfolge Z bei der das Resultat der Bewegungserfassung durch meßgeberfremde Zusatzimpulse verändert wird, zur Synchronisation des Referenzimpulses auf die Geberimpulwechsel A und B diese einer Abtastung unterzogen werden, wobei die einer Vor-Abtastung von Z diendenden Abtastimpulse zeitlich denen der Geberphasen A und B leicht nacheilen, um bei einem geberbedingten Nacheilen des Referenzimpulses Z bezüglich der Geberimpulswechsel A und B die rechtzeitige Erfassung desselben dennoch zu gewährleisten und ihn synchron zum Hauptabtastimpuls am Ausgang des Abtasters erscheinen zu lassen.

Die Erfindung umfaßt ferner eine Schaltungsanordnung zur Durchführung der angegebenen Verfahrensweisen. Diese besteht aus einem zweistufigen Abtaster für die Geberimpulsfolgen A, B und Z und, diesem nachgeschaltet, einem Phaseninverter zur Vertauschung und/oder logischen Invertierung der abgetasteten Geberimpulse A' und B', an den ein Impulsmischer zum Einfügen der Fremdimpulse angeschlossen ist, und ferner aus einem Steuerwerk und einem Taktgenerator mit Frequenznormal zum Steuern und Koordinieren der Funktionsabläufe, wobei letzterer zur Taktversorgung mit dem Abtaster, dem Phaseninverter, dem Impulsmischer und dem Steuerwerk in Verbindung steht, und wobei das Steuerwerk zur Verarbeitung der Eingangsbefehle dient und deren Ausführung in dem an dieses angeschlossenen Phaseninverter und dem Impulsmischer initiiert, der als Resultat der Impulsmischung die Quad-Impulse A''' und B''' an die Auswerte-Einheit abgibt, die ferner mit dem Referenzimpuls Z' versorgt wird.

Einen wesentlichen Teil der erfindungsgemäßen Schaltungsanordnung bildet der Abtaster, der in seinem Eingangsteil zwei Störunterdrückungsstufen für die Geberimpulsreihen A und B aufweist, welcher hauptsächlich für jeden Kanal aus zwei D-Flip-Flops mit EX-OR-Gattern besteht. Durch deren Verschaltungsweise ergibt sich eine völlig symmetrische Unterdrückungswirkung sowohl für 0 → 1 wie auch für 1 → 0 Störungen. Diese beruht darauf, daß nach jedem Pegelwechsel bei den Signalen A bzw. B, der länger ist als der zeitliche Abstand zwischen den Taktphasen $\overline{\emptyset\,1}$ und $\overline{\emptyset\,2}$, die Eingangs-D-Flip-Flops in ihre Ausgangslage $\overline{Q} = 1$ zurückkehren, wobei die Ausgänge Q der nachgeschalteten D-Flip-Flops den logischen Zustand von A bzw. B annehmen. Nun können im Rhythmus der Differenz von Pulsfolgefrequenz des Gebersignals und der Abtastrate Zeitpunkte im Abtastraster auftreten, zu denen kein Signalwechsel von A' oder B' erfolgt. Zu diesen Zeitpunkten können nun zusätzliche Signalwechsel von A' oder B' initiiert werden, ohne daß dabei die Impulsfolgefrequenz der resultierenden Quad-Impulse A''' und B''' die Abtastrate der Geberimpulse überschreitet.

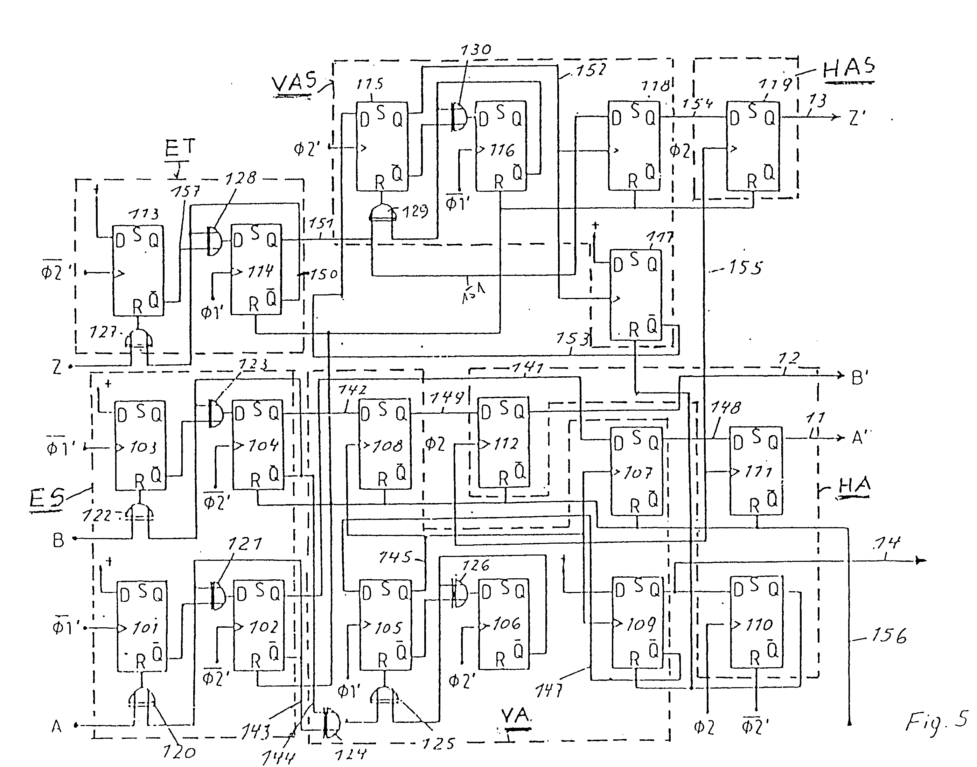

Die erfindungsgemäße Schaltungsanordnung des Abtasters umfaßt somit einen Eingangsteil, bestehend aus jeweils zwei für jeden Kanal A und B vorgesehenen D-Flip-Flops mit zwei EX-OR-Gattern, aus einer Vor-Abtaststufe, bestehend aus fünf weiteren D-Flip-Flops sowie drei EX-OR-Gattern, sowie einer Haupt-Abtaststufe, bestehend aus drei D-Flip-Flops, und bei der der Eingangsteil zwei symmetrisch arbeitende Störunterdrückungsstufen für 0 → 1 und für 1 → 0 Störungen bildet, bei denen die D-Flip-Flop-Ausgänge über EX-OR-Verknüpfungen mit den D-Eingängen der entsprechend den Taktphasen getriggerten Flip-Flops verbunden sind und bei der die Ausgänge der Eingangsstufe mit den Eingängen der Vor-Abtaststufe verbunden sind, und wobei die Ausgänge der D-Flip-Flops zusätzlich über Leitungen über ein EX-OR-Gatter verknüpft sind und über ein weiteres EX-OR-Gatter dem Rücksetzeingang von Flip-Flop zugeführt werden, dessen Ausgang die drei Vor-Abtaststufen gehörenden Flip-Flops triggert, deren Ausgänge die Eingangssignale für die zwei zur Haupt-Abtaststufe gehörenden Flip-Flops sind, die ihrerseits vom Ausgang des mit dem Hauptabtast-Takt getriggerten Flip-Flops getriggert sind, und wobei der Ausgang der Hauptabtaststufe das Unterbrechungssignal darstellt (Fig. 5).

Mit der hier beschriebenen Abtast-Schaltungsanordnung zusammen wirkt die erfindungsgemäß zusätzlich angeordnete Schaltung zu der bereits erwähnten Referenzimpuls-Verarbeitung; diese umfaßt einen Eingangsteil, bestehend aus zwei für den Z-Kanal vorgesehenen D-Flip-Flops mit zwei EX-OR-Gattern und aus einer Vor-Abtaststufe, bestehend aus den vier weiteren D-Flip-Flops sowie aus zwei EX-OR-Gattern, und einer Haupt-Abtaststufe aus einem Flip-Flop, bei der der Eingangsteil eine für 0 → 1 und 1 → 0 Störungen symmetrisch arbeitende Stör-Unterdrückungsstufe bildet, bei der die $\overline{Q}$-Ausgänge über das EX-OR-Gatter verknüpft und dem D-Eingang des Flip-Flop zugeführt werden, dessen $\overline{Q}$-Ausgang zusätzlich mit dem Eingang Z über ein EX-OR-Gatter verknüpft und dem R-Eingang des Flip-Flop zugeführt wird, dessen D-Eingang am stationären Highpegel liegt, und bei der beide Flip-Flops über zeitversetzte Taktsignale getriggert sind, und deren Ausgang über eine Leitung der Vor-Abtaststufe zugeführt wird, einerseits über das eine EX-OR-Gatter dem R-Eingang des einen Flip-Flop und andererseits dem D-Eingang des weiteren Flip-Flops, das zusammen mit einem Flip-Flop getriggert ist, wodurch über eine Leitung der D-Eingang des genannten Flip-Flop solange auf Low-Pegel gesetzt bleibt, bis das Flip-Flop der Haupt-Abtaststufe an dessen D-Eingang über eine Leitung das Ausgangssignal der Vor-Abtaststufe ansteht und über eine Leitung vom Ausgang des genannten Flip-Flop synchron zum Erscheinen des Hauptabtastimpulses getriggert ist, und damit der abgetastete Z-Impuls am Q-Ausgang des genannten Flip-Flop erscheint und über Leitung der nachfolgenden Auswerteschaltung zugeführt wird.

Das Einmischen zusätzlicher Signalwechsel in die Impulsfolgen A′ oder B′ hat zur Folge, daß deren Phasenbeziehung aus dem Rhythmus gebracht wird. Um diese gestörte Phasenbeziehung für die nachfolgenden Signalwechsel zu korrigieren und die ursprüngliche Phasenzuordnung wieder herzustellen ist den Abtastfunktionen ein Phaseninverter nachgeschaltet, der nach jedem zusätzlich initiierten Signalwechsel A′ mit B′ vertauscht und – je nach Erfordernis – A′, B′ oder A′ und B′ logisch invertiert. Diesem Vertauschen und Invertieren liegt ein festes Schema zugrunde, und zwar:

$$A'' \rightarrow A' \quad B' \quad \overline{A'} \quad \overline{B'} \quad A' \quad B' \quad \overline{A'} \quad \overline{B'} \quad A'$$
$$B'' \rightarrow B' \quad \overline{A'} \quad \overline{B'} \quad A' \quad B' \quad \overline{A'} \quad \overline{B'} \quad A' \quad B'$$

$\rightarrow \rightarrow \rightarrow \rightarrow \rightarrow \rightarrow \rightarrow \rightarrow \rightarrow \rightarrow \rightarrow \rightarrow \rightarrow$
Rhythmus bei Einfügung positiv wirkender Signalwechsel

$\leftarrow \leftarrow \leftarrow \leftarrow \leftarrow \leftarrow \leftarrow \leftarrow \leftarrow \leftarrow \leftarrow \leftarrow \leftarrow \leftarrow \leftarrow$
Rhythmus bei Einfügung negativ wirkender Signalwechsel

Auf Grund ihrer Periodizität lassen sich diese Vertauschungs- und Invertierungsoperationen über einen 2-bit vor/rück Dual-Zähler, einen 4-bit vor/rück Ringzähler oder ähnliches steuern. Vorzugsweise kann ein 2-bit vor/rück Dualzähler mit Datenselektor und EX-OR-Gattern verwendet werden.

Demzufolge besteht die weitere Schaltungsanordnung nach der Erfindung aus einem Datenselektor mit zwei nachgeschalteten als gesteuerte Inverter wirkende EX-OR-Gattern und einem in Verbindung mit einem weiteren EX-OR-Gatter arbeitenden 2-bit-Dual-vor/rück-Steuerzähler, wobei die Eingänge des das eine EX-OR-Gatter steuernde letztgenannten EX-OR-Gatters die Zählerausgänge Q1 und Q2 sind, und wobei der Steuereingang des zweitgenannten EX-OR-Gatters über eine Leitung mit dem Ausgang Q2 des Zählers verbunden ist, und wobei ferner der Zählerausgang Q1 über weitere Leitungen mit den Eingängen des Datenselektors in Verbindung stehen und in eine der Leitungen ein Inverter eingeschaltet ist, wobei in Abhängigkeit von der Zählrichtung des Steuerzählers die Beziehung zwischen den Ausgängen A″ und B″ einerseits und Eingängen A′ und B′ andererseits das nachstehende Schema aufweist

$$A'' \rightarrow A' \quad B' \quad \overline{A'} \quad \overline{B'} \quad A' \quad B' \quad \overline{A'} \quad \overline{B'} \quad \overline{A'}$$
$$B'' \rightarrow B' \quad \overline{A'} \quad \overline{B'} \quad A' \quad B' \quad \overline{A'} \quad \overline{B'} \quad A' \quad B'$$

$\rightarrow \rightarrow \rightarrow \rightarrow \rightarrow \rightarrow \rightarrow \rightarrow \rightarrow \rightarrow \rightarrow \rightarrow$
Rhythmus bei Einfügung positiv wirkender Signalwechsel

$\leftarrow \leftarrow \leftarrow \leftarrow \leftarrow \leftarrow \leftarrow \leftarrow \leftarrow \leftarrow \leftarrow \leftarrow \leftarrow \leftarrow \leftarrow \leftarrow$
Rhythmus bei Einfügung negativ wirkender Signalwechsel und wobei der Zähler über eine Leitung im Falle des Einfügens eines zusätzlichen Signalwechsels in eine der Geberphasen zur Taktung mit der Haupt-Abtastphase über eine Leitung freigegeben und in Abhängigkeit von dem Richtungssinn des einzufügenden Signalwechsels über eine Leitung in seiner Zählrichtung gesteuert wird.

Zusätzlich initiierte Signalpegelwechsel bei jeweils einer der abgetasteten A′ und B′ können durch Änderung der Zuordnung zwischen diesen einerseits und den das Resultat dieses Impulseinfügungsvorganges repräsentierenden, einer nachfolgenden Auswerte-Einheit zugeführten Signalphasen A‴ und B‴ andererseits, in Abhängigkeit des Richtungssinnes der Zusatzimpulse und der momentan bestehenden Zuordnung erreicht werden. Zur Durchführung dieses Zuordnungsänderung wird ein Impulsmischer vorgeschlagen, der aus einem 2-bit vor/rück-Gray-Code-Zähler besteht, dessen Zähl-Flip-Flops durch das Richtungssteuersignal über zwei EX-OR-Gatter mit seinem aktuellen Ausgangszustand verknüpft ist, deren Ausgänge den jeweiligen D-Eingängen der Zähl-Flip-Flops zugeführt sind, und die über vier NAND-Gatter mittels der abgetasteten und phasenangeglichenen Gebersignale A″ und B″ vorbesetzbar sind, wenn vom Steuerwerk über eine Leitung die Vorbesetzungsfreigabe gegeben wird, wodurch gleichzeitig über ein NOR-Gatter die Taktfreigabe für den Haupt-Abtasttakt zur Taktung der beiden Zähl-Flip-Flops gestoppt ist.

Um eine Vorprogrammierung für die Zahl der einzufügenden zusätzlichen Signalwechsel einschließlich deren Richtungssinn zu ermöglichen ist das Steuerwerk vorgesehen, welches aus einem Abwärtszähler, der durch die Zahl der einzufügenden zusätzlichen Signalwechsel vorbesetzbar ist, besteht, der durch ein mittels des Startbefehls getriggertes Start-Flip-Flop, ein NOR-Gatter und ein weiteres Flip-Flop die Zählfreigabe erhält, sofern kein Unterbrechungs-Signal die Freigabe stoppt und zugleich über ein weiteres Flip-Flop die Vorbesetzungsfreigabe für den Impulsmischer erteilt, und aus einem an den Abwärtszähler angeschlossenes bei Erreichen des Null-Zustandes ein Stoppsignal erzeugendes Flip-Flop, welches das Start-Flip-Flop zurücksetzt, wodurch die aktuelle Impulseinmischungssequenz beendet ist, wobei zugleich der im Steuerwerk enthaltene Vorzeichenspeicher, bestehend aus einem Inverter, zwei UND-Gattern sowie zwei NOR-Gattern, zur Aufnahme des für die nächstfolgende Impulseinmischungssequenz gültigen Vorzeichens vom Start-Flip-Flop gesteuert bereit ist, und wobei der Ausgang des Vorzeichenspeichers die Richtungsvorgabe für den Phaseninverter liefert und zugleich den zugehörigen Richtungssinn für die im Impulsmischer einzufügenden Zusatzimpulse bestimmt.

Für die erfindungsgemäße sequenzielle Logikschaltung ist zum Steuern und Koordinieren der Funktionsabläufe ein Taktgenerator vorgesehen, der einen strukturierten, periodischen Vierphasentakt generiert.

Dieser besteht aus vier D-Flip-Flops mit einem Frequenz-Normal, der zwei Paare jeweils um 90° gegeneinander versetzte symmetrische Impulsreihen $\emptyset 1'$ und $\emptyset 2'$ bzw. $\emptyset 1$ und $\emptyset 2$ erzeugt, die sich paarweise in der Frequenz um den Faktor 2 unterscheiden und untereinander phasenstarr gekoppelt sind, wobei die Taktphasen $\emptyset 1'$ und $\emptyset 2'$ an den Ausgängen der als zweistufige Gray-Code-Zähler geschalteten und synchron vom Frequenznormal getakteten Flip-Flops anliegen, während die Taktphasen $\emptyset 1$ und $\emptyset 2$ von den Flip-Flops abgeleitet sind, die ebenfalls als zweistufige Gray-Code-Zähler verschaltet, jedoch asynchron von den Pasen $\emptyset 1'$ und $\overline{\emptyset 1'}$ getaktet sind, so daß damit eine eindeutige Phasenbeziehung zwischen allen vier Taktphasen sichergestellt ist.

Ein Ausführungsbeispiel der erfindungsgemäßen Verfahrensweise und der Schaltungsanordnung zu deren Durchführung ist in der Zeichnung dargestellt und im folgenden näher erläutert. Es zeigen

Fig. 1 ein Blockschaltbild

Fig. 2 ein Impulsdiagramm

Fig. 3 die Schaltungsanordnung des Taktgenerators

Fig. 4 ein Zeitdiagramm der Taktphasen

Fig. 5 die Schaltungsanordnung des ·Abtasters

Fig. 6 die Schaltungsanordnung des Phaseninverters und eines Teils des Steuerwerks;

Fig. 7 die Schaltungsanordnung eines weiteren Teils des Steuerwerks und des Impulsmischers.

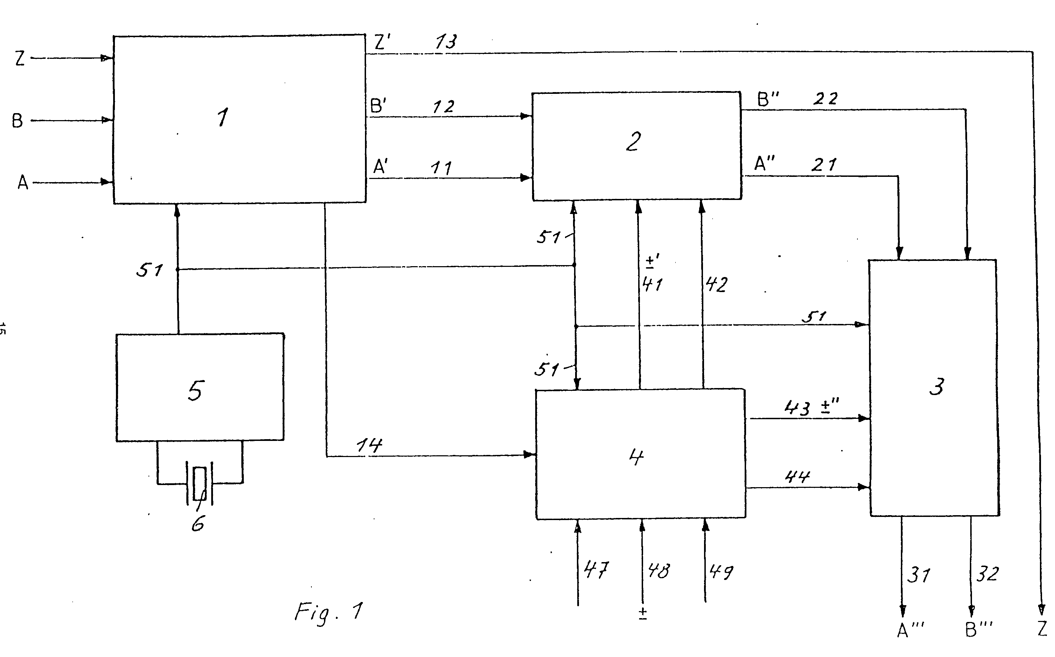

Wie aus dem Blockschaltbild Fig. 1 hervorgeht, setzt sich die Schaltungsanordnung zur Durchführung des Verfahrens aus dem Abtaster 1, dem Phaseninverter 2, dem Impulsmischer 3, dem Steuerwerk 4 und dem Taktgenerator 5 mit Frequenznormal 6 zusammen.

Die Geberphasen A und B und der Referenzimpuls Z werden dem Abtaster 1 zugeführt, die dort über Signal 51 abgetastet werden. Die abgetasteten Geberphasen A' und B' werden über Verbindungen 11 und 12 dem Phaseninverter 2 zugeführt, die in Abhängigkeit vom Richtungssteuersignal 41 und vom Zusatzimpulsmeldesignal 42 eine Phasenkorrektur erfahren. Die phasenkorrigierten Signale A'' und B'' gelangen über Verbindungen 21 und 22 zu den Vorbesetzungseingängen des Impulsmischers 3, der im Falle der Taktfreigabe über Verbindung 44 synchron zum Signal 51 in Abhängigkeit vom Richtungssignal 43 einen zusätzlichen Signalpegelwechsel erzeugt, so daß die dadurch beeinflußten Gebersignale A'' und B'' in Form der Signale A''' und B''' an dessen Ausgängen 31 und 32 erscheinen. Gleichzeitig wird der davon bedienten Auswerte-Einheit der abgetastete Referenzimpuls Z' über Verbindung 13 zugeführt. Im Falle des Nichtauftretens einer Impulswechselpause wird dem Steuerwerk 4 über Verbindung 14 ein Unterbrechungssignal zugeführt, welches die Einfügung der über die Verbindungen 48 und 49 nach Richtungssinn und Anzahl der programmierten Zusatzimpulse nach einem Startbefehl über Verbindung 47 in die nächstfolgende Impulswechselpause bewirkt.

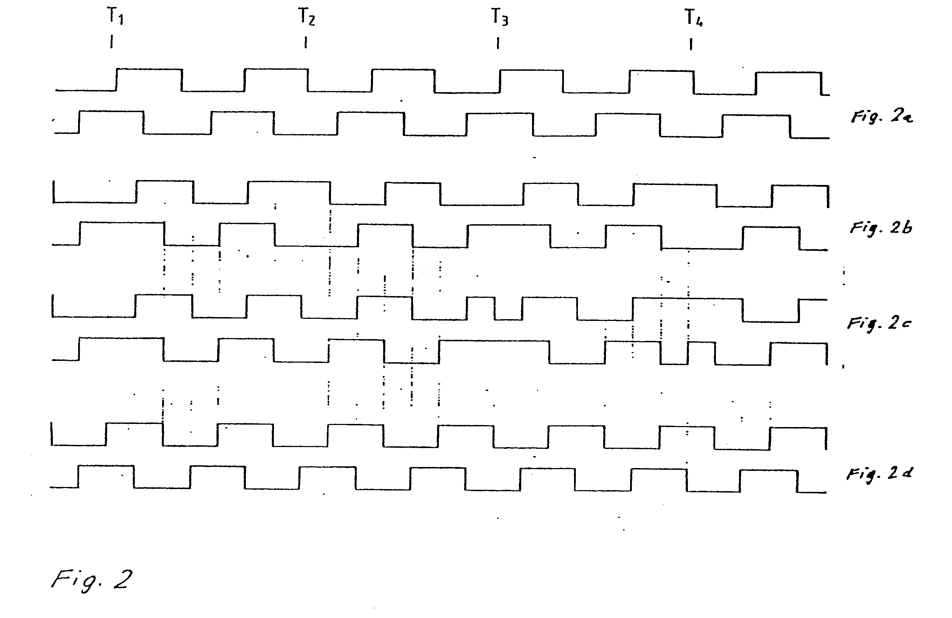

Aus Fig. 2 sind die Impulsreihen ersichtlich, von denen Fig. 2a die Geberimpulsreihen A und B bei gleichförmiger Linksdrehung zeigt. Fig. 2b zeigt die abgetasteten Geberphasen A' und B' gegenüber A und B im Fall einer um ca. 15% erhöhten Abtastrate. Dabei treten zu den Zeitpunkten $T_1$ bis $T_4$ Impulswechselpausen auf. In Fig. 2c sind die abgetasteten und phasenkorrigierten Gebersignale A''' und B''' dargestellt, wobei zum Zeitpunkt $T_1$ kein zusätzlicher Signalwechsel erfolgt, zum Zeitpunkt $T_2$ ein linkssinniger und zum Zeitpunkt $T_3$ und $T_4$ jeweils ein rechtssinniger zusätzlicher Signalwechsel stattfindet. Aus Fig. 2d sind ebenfalls die abgetasteten phasenkorrigierten Gebersignale A''' und B''' ersichtlich, bei denen zu allen vier Zeitpunkten jeweils ein linkssinniger Zusatzimpuls eingefügt wurde; dabei ist zu erkennen, daß sich nach jeweils vier gleichsinnig eingefügten Zusatzimpulsen die Phasenzuordnung zwischen A''' und B''' einerseits und A' und B' andererseits periodisch wiederholt.

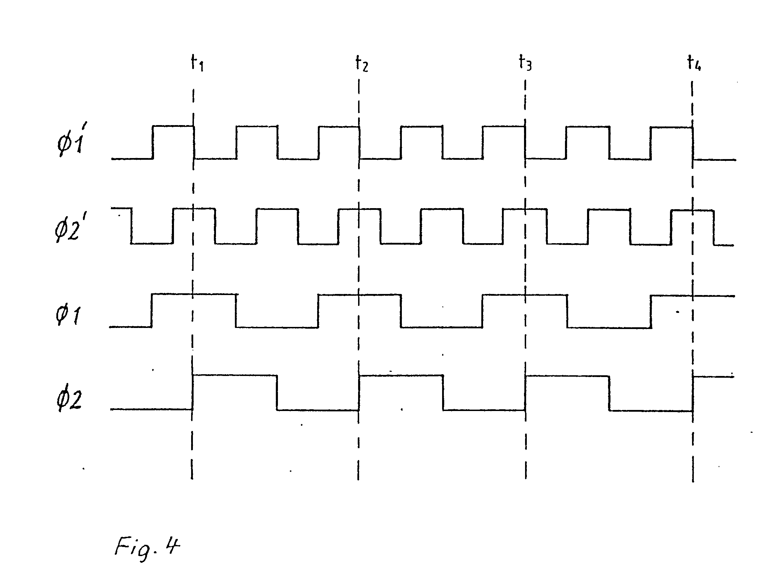

Die Fig. 3 zeigt die den Vierphasentakt generierenden Flip-Flops 501 bis 504 und das diese taktende Frequenznormal 6. Die phasenstarr gekoppelten Taktphasen $\emptyset 1'$ und $\emptyset 2'$ sowie $\emptyset 1$ und $\emptyset 2$ sind in Fig. 4 dargestellt, wobei die Zeitpunkte $T_1$ bis $T_4$ im Hauptabtastraster liegen.

Der in Fig. 5 dargestellte Abtaster gliedert sich den Verarbeitungsteil für die Geberphasen A und B sowie für den Referenzimpuls Z. Bei den Teilen gemeinsam ist für jede Phase jeweils eine Störunterdrückungsstufe am Eingang. Diese besteht für Phase A aus den Flip-Flops 101 und 102 und den NOR-Gattern 120 und 121, während für Phase B die Flip-Flops 103 und 104 sowie die NOR-Gatter 122 und 123 dafür vorgesehen sind. Für die Referenzphase Z besteht die Störunterdrückungsstufe aus den Flip-Flops 113 und 114 sowie den NOR-Gattern 127 und 128.

Zur Vorabtastung dienen für die Phasen A und B die Flip-Flops 105 bis 109, die über die Leitungen 141 und 142 an die Störunterdrückungsstufen angeschlossen sind. Dabei registriert Flip-Flop 105 einen Signalwechsel bei A oder B und triggert die Flip-Flops 107 bis 109 über Leitung 145. Das Flip-Flop 106 dient zum Löschen des Triggers.

Die Ausgänge der Vorabtast-Flip-Flops 107 und 108 bedienen über Leitungen 148. 149 die Eingänge der Hauptabtast-Flip-Flops 111 und 112. die synchron zum Hauptabtastraster die abgetasteten Geberimpulse A' und B' erzeugen, und die über Verbindungen 11, 12 zum Phaseninverter 2 zugeführt werden. Zugleich wird ein vom Flip-Flop 109 generiertes Unterbrechungssignal 14 vom Flip-Flop 110 gelöscht.

Über die Verbindung 151 sind an die Störunterdrückungsstufe für den Z-Impuls die die zur Vorabtastung dienenden Flip-Flops 115 bis 118 angeschlossen. Dabei sperrt Flip-Flop 117 über Verbindung 153 die Eingangsstufe der Vorabtastung, Flip-Flop 115 solange, bis über Verbindung 155 das Hauptabtast-Flip-Flop 119 über den Ausgang von Flip-Flop 110 getriggert wird. Sein Ausgang leitet über Verbindung 13 den abgetasteten Referenzimpuls Z' an die Auswerte-Einheit weiter.

Zur Herstellung eines definierten Signalzustandes A''' = A und B''' = B und Z' = Z sowie zur Verhinderung eines unkontrollierten Auslösens von Simulationsimpulsen beim Anlegen der Betriebsspannung wird dem Abtaster über Leitung 156 ein Rücksetzsignal zugeführt.

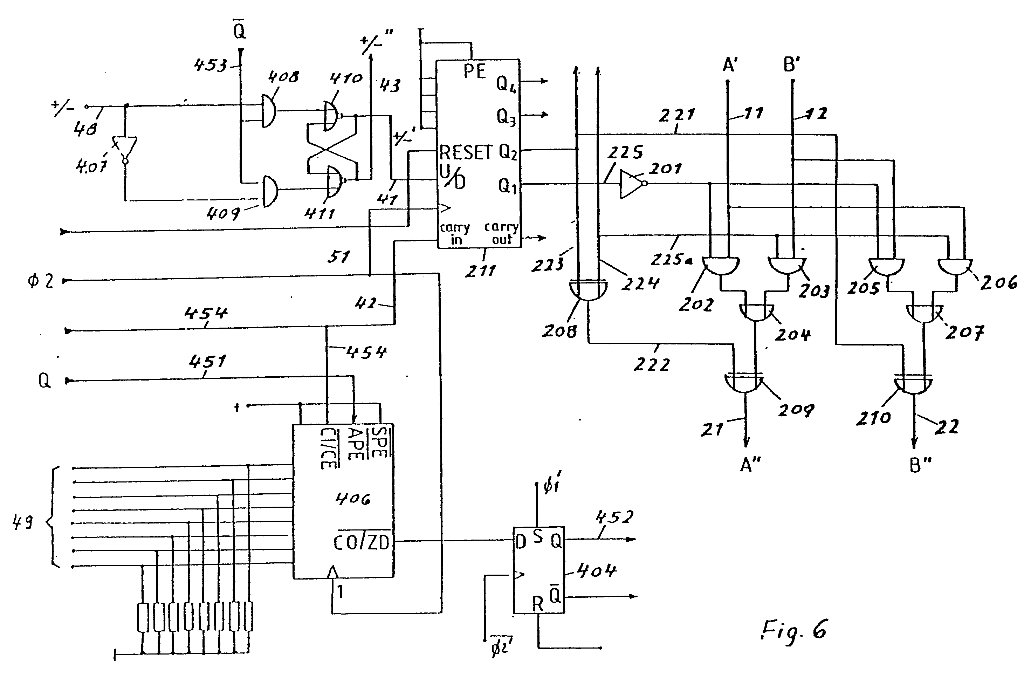

Die in Fig. 6 in der rechten Darstellungshälfte gezeigte Schaltungsanordnung stellt den Phaseninverter dar und besteht aus dem Steuerzähler 211, dem Datenselektor aus den Gattern 201 bis 207 und gesteuerten Invertern 208 bis 210.

Die Ausgänge des Zählers 211 steuern über Leitung 225 und den Inverter 201 die Gatter 202 und 205 und über Leitung 225a die Gatter 203, 206, sowie über Leitung 221 den Steuereingang des EX-OR-Gatters 210 und werden die Verbindungen 223 und 224 über EX-OR-Gatter 208 verknüpft. Sein Ausgang steuert über Leitung 222 den Steuereingang des EX-OR-Gatters 209.

Entsprechend der Stellung des Steuerzählers 211 wird die richtige Zuordnung zwischen den über Leitungen 11, 12 zugeführten abgetasteten Geberphasen A' und B' einerseits und den über Verbindungen 21 und 22 dem Impulsmischer zugeführten Phasen A'' und B'' hergestellt.

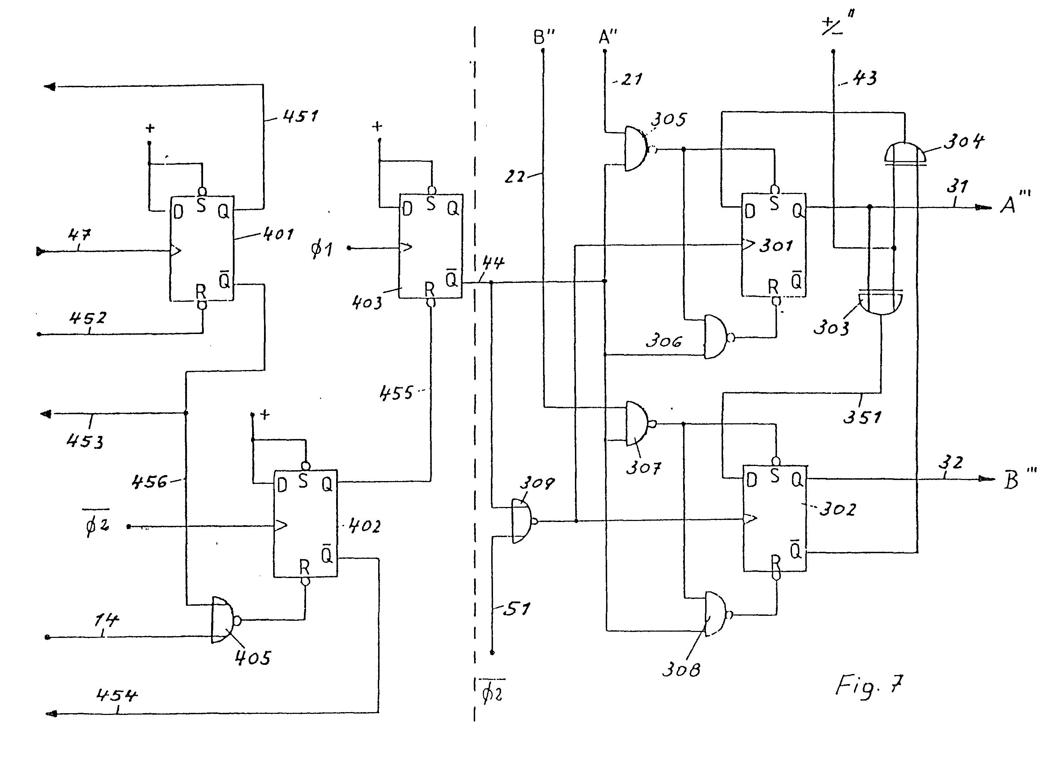

In dem bereits erwähnten Teil des Steuerwerkes – siehe Fig. 6 linke Darstellung – ist der Abwärtszähler mit 406 bezeichnet, der über Flip-Flop 404 ein Ausgangssignal 452 (Stoppsignal) für das Start-Flip-Flop 401 – siehe Fig. 7 – erzeugt.

Der Abwärtszähler 406 wird über Leitung 49 vorprogrammiert. Er erhält sein Programmiersignal 451 über Flip-Flop 401 (Fig. 7). Das Freigabesignal ist über Leitung 42 mit dem Freigabe-Eingang des Zählers 211 verbunden und wird gemeinsam über Leitung 454 vom Flip-Flop 402 (Fig. 7) bedient. Beide Zähler 406 und 211 erhalten ihr gemeinsames Taktsignal über Leitung 51 vom Taktgenerator 5 (Fig. 1 und 3).

Das Richtungssteuersignal 41 des Zählers 211 liefert das NOR-Gatter 410, dessen Ausgang mit einem Eingang des NOR-Gatters 411 verbunden ist. Sein Ausgang ist mit einem Eingang des NOR-Gatters 410 verbunden und liefert über Verbindung 43 das Richtungssteuersignal für den Impulsmischer 3 (Fig. 1 und 7), und ist dort mit jeweils einem Eingang des EX-OR-Gatters 303 und 304 verbunden. Der jeweils andere Eingang der NOR-Gatter 410 und 411 werden vom Ausgang jeweils eines UND-Gatters 408 und 409 bedient. bei denen jeweils ein Eingang zusammengelegt ist und über Leitung 453 mit Flip-Flop 401 (Fig. 7) verbunden ist. Die anderen beiden Eingänge von den UND-Gattern 408 und 409 sind über einen Inverter 407 so verbunden, daß der Ausgang des Inverters mit dem Eingang des UND-Gatters 409 verbunden und der Eingang gemeinsam mit dem Eingang des UND-Gatters 408 über Leitung 49 das Signal für den Richtungssinn der Zusatzimpulse erhält.

Die Fig. 7 – linke Darstellung – zeigt den zweiten Teil des Steuerwerks 4 (Fig. 1), und zwar erhält das Start-Flip-Flop 401 sein Startsignal über den peripheren Eingang Leitung 47. Über Leitung 456 ist sein invertierter Ausgang mit einem Eingang des NOR-Gatters 405 verbunden, dessen anderer Eingang – Leitung 14 – mit dem Ausgang des Flip-Flops 109 (Fig. 5) verbunden ist.

Der Ausgang Q des Flip-Flops 402 geht über Leitung 455 an den Rücksetz-Eingang des Flip-Flops 403. Sein invertierter Ausgang 44 ist mit jeweils einem Eingang der NAND-Gatter 305 bis 308 sowie mit einem Eingang des NOR-Gatters 309 verbunden. Der andere Eingang des NOR-Gatters 309 wird über Verbindung 51 mit dem entsprechenden Takt versorgt.

Der weitere Eingang des NAND-Gatters 305 erhält das Signal A'' über Verbindung 21 vom Ausgang des Phaseninverters 2, Gatter 209 (Fig. 6). Der andere Eingang des NAND-Gatters 207 erhält das Signal B'' über die Verbindung 22 vom Ausgang des Phaseninverters 2, Gatter 210 (Fig. 6).

Der jeweils andere Eingang der NAND-Gatter 306 und 308 ist mit dem Ausgang des NAND-Gatters 305 bhw. 307 verbunden, und gleichzeitig mit dem jeweiligen S-Eingang der Flip-Flops 301 bzw. 302. Der jeweilige Rücksetzeingang der Flip-Flops 301 und 302 ist mit dem Ausgang des NAND-Gatters 306 bzw. 308 verbunden. Der jeweilige D-Eingang der Flip-Flops 301, 302 ist mit dem Ausgang der bereits erwähnten EX-OR-Gatter 303 bzw. 304 über Leitungen 350, 351 verbunden. Ihr jeweils noch freier Eingang steht einerseits mit dem Ausgang des Flip-Flops 301 und andererseits mit dem invertierten Ausgang des Flip-Flops 302 in Verbindung. Die Ausgänge der Flip-Flops 301 und 302 stellen die Signale A''' und B''' über Leitung 31 und 32 der Auswerte-Einheit zur Verfügung.

**Patentansprüche**

1. Verfahren zur Beeinflussung der Quad-Impulse von inkrementalen Meßsystemen zum Erfassen der Bewegungen ein- oder mehrachsig zueinander verschieb- und/oder verdrehbarer Elemente an maschinellen Vorrichtungen, insbes. Werkzeugmaschinen, bei dem die Impulsfolgen der Inkrementalgeber zur Korrektur von Positionierfehlern oder zur kontrollierten Überlagerung von Zusatzbewegungen mit einer Frequenz abgetastet werden, die höher als die der max. auftretenden Bewegungsgeschwindigkeit entsprechende Frequenz liegt, und bei welchem das Resultat der Bewegungserfassung durch meßgeberfremde Zusatzimpulse veränderbar ist, wobei ferner beim Abtasten der Geberimpulsreihen A und B mit einer über der durch Exklusiv-Oder-Verknüpfung entstehenden Pegelwechselfrequenz liegenden Abtastrate die am Ausgang des Abtasters im Rhythmus der Differenz zwischen beiden Frequenzen auftretenden Impulswechselpausen zum Einfügen geberfremder Zusatzsignale ausgenutzt werden, wobei die Impulswechselpausen so rechtzeitig erfaßt werden, daß ein kontrollierter, in sich abgeschlossener Impulseinfügungsvorgang eingeleitet wird, der aus einem zusätzlich initiierten Signalpegelwechsel bei einer der beiden abgetasteten, eine Phasenkorrektur aufweisenden Geberimpulsreihen A' und B' besteht.

2. Verfahren nach Anspruch 1, dadurch gekennzeichnet, daß durch Vorabtastung der Geberphasen A' und B', mittels gegenüber den Abtastimpulsen zeitversetzter Vorabtastimpulse, im Falle des Auftretens eines Pegelwechsels bei A' oder B', ein Unterbrechungssignal so rechtzeitig erzeugt wird, daß ein eingeleiteter und zum nächsten Abtastzeitpunkt vorgesehener zusätzlicher Signalpegelwechsel bei einer der beiden am Ausgang des Abtasters vorliegenden abgetasteten Geberphasen A' und B' solange zurückgehalten wird, bis er in die nächstfolgende Impulswechselpause eingefügt wird.

3. Verfahren nach Anspruch 1 und 2, dadurch gekennzeichnet, daß zusätzlich initiierte Signalpegelwechsel bei jeweils einer der abgetasteten Geberphasen A' und B' durch Änderung der Zuordnung zwischen diesen einerseits und den das Resultat dieses Impulseinfügungsvorganges repräsentierenden, einer nachfolgenden Auswerteeinheit zugeführten Signalphasen A''' und B''' andererseits, in Abhängigkeit des Richtungssinnes der Zusatzimpulse und der momentan bestehenden Zuordnung, gemäß nachstehendem Schema veranlaßt werden.

$$A''' \rightarrow A' \quad B' \quad \overline{A'} \quad \overline{B'} \quad A' \quad B' \quad \overline{A'} \quad \overline{B'} \quad A'$$
$$B''' \rightarrow B' \quad \overline{A'} \quad \overline{B'} \quad A' \quad B' \quad \overline{A'} \quad \overline{B'} \quad A' \quad B'$$

$$\rightarrow \rightarrow \rightarrow \rightarrow \rightarrow \rightarrow \rightarrow \rightarrow \rightarrow \rightarrow \rightarrow \rightarrow$$

wobei ein Signalzuordnungswechsel in diesem Schema nach rechts eine linkssinnige Einfügung und umgekehrt bedeutet.

$$\leftarrow \leftarrow \leftarrow \leftarrow \leftarrow \leftarrow \leftarrow \leftarrow \leftarrow \leftarrow \leftarrow \leftarrow$$

4. Verfahren nach einem der Ansprüche 1 bis 3, dadurch gekennzeichnet, daß Abtaster-Eingangssignalwechsel $0 \rightarrow 1$ bzw. $1 \rightarrow 0$ von kürzerer Dauer als der Dauer der die Information enthaltenden Nutzsignalwechsel dadurch unterdrückt werden, daß deren Länge in einer sequenziell arbeitenden Logikanordnung über zwei zeitlich versetzte Taktphasen gemessen und in Abhängigkeit vom Meßergebnis unterdrückt oder weitergeleitet werden.

5. Verfahren nach Anspruch 4, gekennzeichnet durch zwei D-Flip-Flops, deren $\overline{Q}$-Ausgänge über eine EX-OR-Verknüpfung dem D-Eingang eines der beiden mit einer der Taktphasen getriggerten Flip-Flops zugeführt werden, dessen $\overline{Q}$-Ausgang gleichzeitig über eine weitere EX-OR-Verknüpfung mit dem Eingangssignal dem Rücksetzeingang des anderen der beiden mit der zweiten Taktphase getriggerten Flip-Flops zugeführt wird, dessen D-Eingang einen stationären High-Pegel erhält, und wobei der $\overline{Q}$-Ausgang des erstgenannten Flip-Flops das Ausgangssignal darstellt.

6. Verfahren nach Anspruch 4, dadurch gekennzeichnet, daß zur Synchronisation des Referenzimpulses Z auf die Geberimpulswechsel A und B diese einer Abtastung unterzogen werden, wobei die einer Vor-Abtastung von Z dienenden Abtastimpulse zeitlich denen der Geberphasen A und B leicht nacheilen, um bei einem geberbedingten Nacheilen des Referenzimpulses Z bezüglich der Geberimpulswechsel A und B die rechtzeitige Erfassung desselben dennoch zu gewährleisten und ihn synchron zum Hauptabtastimpuls am Ausgang des Abtasters erscheinen zu lassen.

7. Schaltungsanordnung zur Durchführung des Verfahrens nach den Ansprüchen 1 bis 3 mit einem zweistufigen Abtaster (1) für die Geberimpulsfolgen A, B und Z und, diesem nachgeschaltet, einem Phaseninverter (2) zur Vertauschung und/oder logischen Invertierung der abgetasteten Geberimpulse A' und B', an den über die Verbindungen (21, 22) ein Impulsmischer (3) zum Einfügen von Fremdimpulsen angeschlossen ist, und ferner mit einem Steuerwerk (4) und einem Taktgenerator (5) mit Frequenznormal (6) zum Steuern und Koordinieren der Funktionsabläufe, wobei letzterer zur Taktversorgung mit dem Abtaster (1), dem Phaseninverter (2), dem Impulsmischer (3) und dem Steuerwerk (4) in Verbindung steht, und wobei das Steuerwerk (4) zur Verarbeitung der Eingangsbefehle (47, 48, 49) dient und deren Ausführung in dem an dieses angeschlossenen Phaseninverter (2) und dem Impulsmischer (3) initiiert, der als Resultat der Impulsmischung die Quad-Impulse A''' und B''' an die Auswerte-Einheit abgibt, die ferner mit dem Referenzimpuls Z' versorgt wird.

8. Schaltungsanordnung nach Anspruch 7, gekennzeichnet durch eine Eingangsstufe (ES), bestehend aus einer ersten Gruppe (I) von jeweils zwei für jeden Kanal A und B vorgesehenen D-Flip-Flops (101, 102 bzw. 103, 104) und je zwei EX-OR-Gattern (120, 121 bzw. 122, 123), aus einer Vor-Abtaststufe (VA), bestehend aus einer zweiten Gruppe (II) von fünf weiteren D-Flip-Flops (105 bis 109) sowie drei EX-OR-Gattern (124 bis 126), sowie einer Haupt-Abtaststufe (HA), bestehend aus einer dritten Gruppe (III) von drei D-Flip-Flops (110 bis 112), und dadurch, daß die Eingangsstufe (ES) zwei symmetrisch arbeitende Störunterdrückungsstufen für $0 \rightarrow 1$ und für $1 \rightarrow 0$ Störungen

bildet. bei denen die Q-Ausgänge der D-Flip-Flops (102, 104) über Leitungen (143, 144) über die EX-OR-Gatter (121, 123) mit den D-Eingängen der entsprechend den Taktphasen getriggerten D-Flip-Flops (102, 104) verbunden sind, deren Ausgänge über Leitungen (143, 144) gleichzeitig über die EX-OR-Gatter (120, 122) mit den Eingängen A und B verknüpft, den R-Eingängen der zeitversetzt getriggerten D-Flip-Flops (101, 103) zugeführt werden, deren D-Eingänge an stationärem High-Pegel liegen, und bei der die Ausgänge (141, 143) der Eingangsstufe (ES) mit den Eingängen der Vor-Abtaststufe (VA) verbunden sind, und wobei die Ausgänge der D-Flip-Flops (102, 104) zusätzlich über Leitungen (143, 144) über ein EX-OR-Gatter (124) verknüpft sind und über ein weiteres EX-OR-Gatter (125) dem Rücksetzeingang von Flip-Flop (105) zugeführt werden, dessen Ausgang (145) die drei zur Vor-Abtaststufe (VA) gehörenden Flip-Flops (107 bis 109) triggert, deren Ausgänge (148, 149) die Eingangssignale für die zwei zur Haupt-Abtasterstufe (HA) gehörenden Flip-Flops (111, 112) sind, die ihrerseits vom Ausgang des mit dem Hauptabtast-Takt getriggerten Flip-Flops (110) getriggert sind, und wobei der Ausgang (14) der Hauptabtaststufe (HA) das Unterbrechungssignal darstellt.

9. Schaltungsanordnung nach Anspruch 8, zur Referenzimpuls-Verarbeitung, gekennzeichnet durch einen Eingangsteil (ET), bestehend aus einer vierten Gruppe (IV) von zwei für den Z-Kanal vorgesehenen D-Flip-Flops (113, 114) mit zwei EX-OR-Gattern (127, 128) und aus einer Vor-Abtaststufe (VAS), bestehend aus einer fünften Gruppe (V) von vier weiteren D-Flip-Flops (115 bis 118) sowie aus zwei EX-OR-Gattern (129, 130), und einer Haupt-Abtaststufe (HAS) aus einem Flip-Flop (119), bei der der Eingangsteil (ET) eine für $0 \rightarrow 1$ und $1 \rightarrow 0$ Störungen symmetrisch arbeitende Stör-Unterdrückungsstufe bildet, bei der die $\overline{Q}$-Ausgänge (150, 157) über das EX-OR-Gatter (128) verknüpft und dem D-Eingang des Flip-Flops (114) zugeführt werden, dessen $\overline{Q}$-Ausgang zusätzlich mit dem Eingang Z über ein EX-OR-Gatter (127) verknüpft und den R-Eingang des Flip-Flops (113) zugeführt wird, dessen D-Eingang am stationären Highpegel liegt, und bei der beide Flip-Flops (113, 114) über zeitversetzte Taktsignale getriggert sind und deren Ausgang über Leitung (151) der Vor-Abtaststufe (VAS) zugeführt wird, einerseits über das eine EX-OR-Gatter (129) dem R-Eingang des einen Flip-Flops (115) und andererseits dem D-Eingang des weiteren Flip-Flops (118), das zusammen mit Flip-Flop (117) über Leitung (152) vom $\overline{Q}$-Ausgang des Flip-Flops (115) getriggert ist, wodurch über eine Leitung (153) der D-Eingang des genannten Flip-Flops (115) solange auf Low-Pegel gesetzt bleibt, bis das Flip-Flop (119) der Haupt-Abtaststufe (HAS) an dessen D-Eingang über eine Leitung (154) das Ausgangssignal der Vor-Abtaststufe (VAS) ansteht und über eine Leitung (155) vom Ausgang des genannten Flip-Flops (110) synchron zum Erscheinen des Hauptabtastimpulses getriggert ist, und damit der abgetastete Z-Impuls am Q-Ausgang des genannten Flip-Flops (119) erscheint und über Leitung (13) der nachfolgenden Auswerteschaltung zugeführt wird.

10. Schaltungsanordnung nach Anspruch 7, gekennzeichnet durch einen Datenselektor (201 bis 207) mit zwei nachgeschalteten als gesteuerter Inverter wirkenden EX-OR-Gattern (209, 210) und einem in Verbindung mit einem weiteren EX-OR-Gatter (208) arbeitenden 2 bit-Dual-vor/rück-Steuerzähler (211), wobei die Eingänge des das eine EX-OR-Gatter (209) steuernden letzgenannten EX-OR-Gatters (208) die Zählerausgänge Q1 (224) und Q2 (223) sind, und wobei der Steuereingang des zweitgenannten EX-OR-Gatters (210) über eine Leitung (221) mit dem Ausgang Q2 des Zählers (211) verbunden ist, und wobei ferner der Zählerausgang Q1 über weitere Leitungen (225, 225a) mit den Eingängen des Datenselektors (201 bis 207) in Verbindung stehen und in einer der Leitungen (225) ein Inverter (201) eingeschaltet ist, wobei in Abhängigkeit von der Zählrichtung des Steuerzählers (211) die Beziehung zwischen den Ausgängen A'' und B'' einerseits und Eingängen A' und B' andererseits das nachstehende Schema aufweist

$$A'' \rightarrow A' \quad B' \quad \overline{A'} \quad \overline{B'} \quad A' \quad B' \quad \overline{A'} \quad \overline{B'} \quad A'$$
$$B'' \rightarrow B' \quad \overline{A'} \quad \overline{B'} \quad A' \quad B' \quad \overline{A'} \quad \overline{B'} \quad A' \quad B'$$

wobei ein Signalzuordnungswechsel in diesem Schema nach rechts eine linkssinnige Einfügung und umgekehrt bedeutet und wobei der Zähler (211) über eine Leitung (42) im Falle des Einfügens eines zusätzlichen Signalwechsels in eine der Geberphasen zur Taktung mit der Haupt-Abtastphase über eine Leitung (51) freigegeben, und in Abhängigkeit von dem Richtungssinn des einzufügenden Signalwechsel über eine Leitung (41) in seiner Zählrichtung gesteuert wird.

11. Schaltungsanordnung nach Anspruch 7 und einem oder mehreren der folgenden Ansprüche, gekennzeichnet durch einen Impulsmischer (3) der aus einem 2 bit vor/rück-Gray-Code-Zähler (301 bis 309) besteht, dessen Zähl-Flip-Flops (301, 302) durch das Richtungssteuersignal (Leitung 43) über zwei EX-OR-Gatter (303, 304) mit seinem aktuellen Ausgangszustand verknüpft ist, deren Ausgänge (Leitungen 350, 351) den jeweiligen D-Eingängen der Zähl-Flip-Flops (301 bzw. 302) zugeführt sind, und die über vier NAND-Gatter (305 bis 308) mittels der abgetasteten und phasenangeglichenen Gebersignale A'' und B'' vorsetzbar sind, wenn vom Steuerwerk (4) über eine Leitung (44) die Vorsetzungsfreigabe gegeben wird, wodurch gleichzeitig über ein NOR-Gatter (309) die Taktfreigabe für den Haupt-Abtasttakt (Leitung 51) zur Taktung der beiden Zähl-Flip-Flops (301, 302) gestoppt ist.

12. Schaltungsanordnung nach Anspruch 7 und einem oder mehreren der folgenden Ansprüche, gekennzeichnet durch einen Abwärtszähler (406), der durch die Zahl der einzufügenden zusätzlichen Signalwechsel vorsetzbar (Leitung 49) ist, und der durch ein mittels des Startbefehls (Leitung 47) getriggertes Start-Flip-Flop (401) ein NOR-Gatter (405) und ein weiteres Flip-Flop (402) die Zählfreigabe erhält, sofern kein Unterbrechungssignal (Leitung 14) die Freigabe stoppt, und zugleich über ein weiteres Flip-Flop (403) die Vorsetzungsfreigabe für den Impulsmischer (3) über Leitung (44) erteilt, und ferner durch ein an den Abwärtszähler (406) angeschlossenes, bei Erreichen
des Null-Zustandes ein Stopp-Signal (Leitung 452)
erzeugendes Flip-Flop (404), welches das Start-
Flip-Flop (401) zurücksetzt, wodurch die aktuelle
Impulseinmischungssequenz beendet ist, wobei
zugleich der im Steuerwerk (4) enthaltene Vorzeichenspeicher, bestehend aus einem Inverter
(407), zwei UND-Gattern (408, 409) sowie zwei
NOR-Gattern (410, 11), zur Aufnahme der für die
nächstfolgende Impulseinmischungssequenz gültigen Vorzeichens vom Start-Flip-Flop (401) gesteuert (Leitung 453) bereit ist und wobei der Ausgang (41) des Vorzeichenspeichers die Richtungsvorgabe für den Phaseninverter liefert und zugleich den zugehörigen Richtungssinn für die im
Impulsmischer (3) einzuführenden Zusatzimpulse
bestimmt.

13. Schaltungsanordnung nach Anspruch 8 und
einem oder mehreren der folgenden Ansprüche,
gekennzeichnet durch einen aus vier D-Flip-Flops
(501 bis 504) bestehenden Vierphasen-Taktgenerator (5) mit einem Frequenz-Normal (6), der zwei
Paare um 90° gegeneinander versetzte symmetrische Impulsreihen Ø 1' und Ø 2' bzw. Ø 1 und Ø 2
erzeugt, die sich paarweise in der Frequenz um
den Faktor 2 unterscheiden und untereinander
phasenstarr gekoppelt sind, wobei die Taktphasen
Ø 1' und Ø 2' an den Ausgängen der als zweistufige
Gray-Code-Zähler geschalteten und synchron
vom Frequenz-Normal (6) getakteten Flip-Flops
(501, 502) anliegen, während die Taktphasen Ø 1
und Ø 2 von den Flip-Flops (503, 504) abgeleitet
sind, die ebenfalls als zweistufige Gray-Code-
Zähler verschaltet, jedoch asynchron von den
Phasen Ø 1' und $\overline{Q\,1'}$ getaktet sind, so daß damit
eine eindeutige Phasenbeziehung zwischen allen
vier Taktphasen sichergestellt ist.

**Claims**

1. Process for treating quadrature pulses in incremental measuring systems to detect the movement of components, displaceable and/or rotating
towards each other on one or several axes, with
mechanic devices, especially with machine tools,
allowing to scan the pulse trains of incremental
generators, for the rectification of positioning errors or for the controlled superposition of additional movements, at a frequency which exceeds that
corresponding to the maximum speed of movement, and this process further allowing to modify
the result of the detection of movements by additional pulses external to the generator and to use
the pulse change intervals that occur on scanning
the generator pulse trains A and B at a rate exceeding the level change frequency resulting from
an Exclusive-OR operation and which are available at the scanner output in the rhythm of the
difference between both frequencies for the insertion of additional signals external to the generator, and this scanning further allows to detect the
pulse change intervals so early that a controlled
and fully closed pulse inserting operation is started, the latter comprising an additionally initiated
change of the signal level with either scanned and
phase-corrected generator pulse trains A' and B'.

2. Process acc. to claim 1, characterized in that,
by preliminary scanning of generator phases A'
and B' as well as by means of pre-scan pulses that
are time-shifted against the scanning pulses, on
occurrence of a level change with A' or B', an
interrupt signal will be generated so early that
another change of the signal level, initiated and
provided for the next scanning instant, will be
retained with one of the generator phases A' and
B', scanned and available at the scanner output,
until it will be inserted into the next pulse change
interval.

3. Process acc. to claims 1 and 2, characterized
in that with each of the scanned generator phases
A' and B', some additionally initiated changes of
the signal level by the modified assignment of the
latter on the one hand to the signal phases A''' and
B''' representing the result of this insertion of
pulses and having been transmitted to a subsequent evaluator on the other hand will be caused
depending on the sense of direction of the additional pulses and the actual assignment, in accordance with the following diagram

$$A''' \rightarrow \quad A' \quad B' \quad \overline{A'} \quad \overline{B'} \quad A' \quad B' \quad \overline{A'} \quad \overline{B'} \quad A'$$
$$B''' \rightarrow \quad B' \quad \overline{A'} \quad \overline{B'} \quad A' \quad B' \quad \overline{A'} \quad \overline{B'} \quad A' \quad B'$$

$$\rightarrow \; \rightarrow \; \rightarrow \; \rightarrow \; \rightarrow \; \rightarrow \; \rightarrow \; \rightarrow \; \rightarrow \; \rightarrow \; \rightarrow \; \rightarrow$$

and with such pulse insertion, a change of the
signal assignment, in this diagram, to the right
means a left-handed insertion and viceversa.

$$\leftarrow \; \leftarrow \; \leftarrow \; \leftarrow \; \leftarrow \; \leftarrow \; \leftarrow \; \leftarrow \; \leftarrow \; \leftarrow \; \leftarrow \; \leftarrow$$

4. Process acc. to one of the claims 1 to 3,
characterized in that the changes of the scanner
input signal $0 \rightarrow 1$ or $1 \rightarrow 0$, if shorter than the
changes of the useful signals containing the information, will be suppressed by testing their
length in a sequentially operating logical array
over two time-displaced clock phases and eliminating or transmitting them as a function of the
test result.

5. Process acc. to claim 4, characterized by two
D flip-flops of which the $\overline{Q}$ output signals are
applied, via an EX-OR operation, to the D input of
either flip-flop that has been triggered by one of
the clock phases and of which the $\overline{Q}$ output signal
is simultaneously fed, via a further EX-OR operation and together with the input signal, to the reset
input of the other flip-flop, triggered by the second
clock phase, and to the D input of which a stationary high level is being applied, and with said
process the $\overline{Q}$ output of the flip-flop mentioned at
first represents the output signal.

6. Process acc. to claim 4, characterized in that,
for synchronizing the reference pulse Z and the
changes of the generator pulses A and B, these
are subject to a scan operation where the pulses that serve the prescanning of Z lag somewhat behind those of the generator phases A and B so that, in case of a lagging reference pulse Z, related to generator pulse changes A and B, which is conditioned by the generator, the timely collection of pulse Z is yet ensured and its application at the scanner output and the occurrence of the main scanning pulse are perfectly synchronized.

7. Circuit for the implementation of the process acc. to claims 1 to 3 using a two-stage scanner (1) for the generator pulse trains A, B and Z as well as a subsequent phase inverter (2) for the interchange and/or logical inversion of the scanned generator pulses A′ and B′ to which, via links (21, 22), a pulse mixer (3) has been connected for insertion of external pulses, this circuit being provided with a control unit (4) and a clock generator (5) with standard frequency generator (6) for the control and coordination of functional sequences, the latter being connected to the scanner (1), the phase inverter (2), the pulse mixer (3) and the control unit (4) for the clock pulse supply, and the control unit (4) processing the input instructions (47, 48, 49) and initiating their execution by the phase inverter (2), linked to said unit, as well as by the pulse mixer (3) which, as a result of pulse mixing, transmits the quad pulses A‴ and B‴ to the evaluator being supplied with the reference pulse Z′.

8. Circuit acc. to claim 7, characterized by an input stage (ES) comprising a first module (I) of D flip-flops (101, 102 and 103, 104 resp.), two each for channel A and B, as well as of two each EX-OR gates (120, 121 and 122, 123 resp.), a prescanning stage (VA) comprising a second module (II) of five D flip-flops (105 to 109), three EX-OR gates (124 to 126) as well as a main scanning stage (HA) comprising a third (III) module of three D flip-flops (110 to 112), said circuit being further characterized by the input stage (ES) forming two balanced suppression stages for $0 \rightarrow 1$ and $1 \rightarrow 0$ noises, on which the Q outputs of the D flip-flops (102, 104) are linked, via leads (143, 144) and EX-OR gates (121, 123) to the D inputs of the D flip-flops (102, 104), triggered acc. to the clock pulse phases, of which the outputs are linked, via leads (143, 144), simultaneously connected to the inputs A and B via the EX-OR gates (120, 122), to the R inputs of the D flip-flops (101, 103), triggered with time-offset, of which the D inputs are fed with the stationary high level, said circuit having an input stage (ES) of which the outputs (141, 142) are linked to the inputs of the prescanning stage (VA), and on this circuit the outputs of the D flip-flops (102, 104), additionally linked via leads (143, 144) and an EX-OR gate (124), are connected, via a further EX-OR gate (125), to the reset input of the flip-flop (105) of which the output (145) triggers the three flip-flops (107 to 109) pertaining to the prescanning stage (VA), their output signals (148, 149) are fed to the inputs of the two flip-flops (111, 112) pertaining to the main scanning stage (HA) and which are triggered by the output of the flip-flop (110), triggered itself by the main scanning clock, and on this circuit the output (14) of the main scanning stage (HA) represents the interrupt signal.

9. Circuit acc. to claim 8, for the treatment of reference pulses, characterized by an input stage (ET) comprising a fourth module (IV) of two D flip-flops (113, 114), provided for the Z channel, having two EX-OR gates (127, 128), a prescanning stage (VAS) consisting of a fifth module (V) of four D flip-flops (115 to 118) and of two EX-OR gates (129, 130) and a main scanning stage (HAS) consisting of a flip-flop (119) for which the input stage (ET) functions as a balanced stage suppressing $0 \rightarrow 1$ and $1 \rightarrow 0$ noises, on which the $\overline{Q}$ outputs (150, 157) are linked, via the EX-OR gate (128), and connected to the D input of flip-flop (114), of which the $\overline{Q}$ output is additionally linked to the input Z, via an EX-OR gate (127), and connected to the R input of the flip-flop (113), at the D input of which the stationary high level is available, and on this stage both flip-flops (113, 114) are triggered by time-shifted clock pulses and their output is connected, vial lead (151), to the prescanning stage (VAS), on the one hand via one of the EX-OR gates (129) to the R input of one of the flip-flops (115) and on the other hand to the D input of the second flip-flop (118) which is triggered, together with a flip-flop (117) and via a lead (152), by the $\overline{Q}$ output of the flip-flop (115), thus the D input of said flip-flop (115) remains, via lead (153), set to low level until the flip-flop (119) of the main scanning stage (HAS), to the D input of which the output signal of the prescanning stage is applied via a lead (154), has been triggered via a lead (155), synchronously with the occurrence of the main scanning pulse, by the output of said flip-flop (110) and, as a consequence, the scanned Z pulse is applied to the Q output of said flip-flop (119) and transmitted, via lead (13), to the subsequent evaluation circuit.

10. Circuit acc. to claim 7, characterized by a data selector (201 to 207) with two subsequent EX-OR gates (209, 210), which function as a controlled inverter, and a 2-bit dual bidirectional control counter (211), operating in conjunction with a further EX-OR gate (208), the inputs of the EX-OR gate (208) controlling the EX-OR gate (209) represent the counter outputs Q1 (224) and Q2 (223), where the control input of the second EX-OR gate (210) is linked, via lead (221), to the output Q2 of the counter (211) and, moreover, the counter output Q1 is connected, via further leads (225, 225a), to the inputs of the data selector (201 to 207) and in one lead (225) an inverter (201) being inserted, and on this circuit, as a function of the operating direction of the control counter (211), the relationship between the outputs A″ and B″ on the one hand and the inputs A′ and B′ on the other hand is governed by the following diagram

$$A'' \rightarrow A'\ B'\ \overline{A'}\ \overline{B'}\ A'\ B'\ \overline{A'}\ \overline{B'}\ A'$$
$$B'' \rightarrow B'\ \overline{A'}\ \overline{B'}\ A'\ B'\ \overline{A'}\ \overline{B'}\ A'\ B',$$

and according to this diagram, a change in the signal allocation to the right means a left-handed insertion and viceversa, where the counter (211) is released (via a lead (42)), on inserting an additional signal change in one of the phases of the generator, for clocking by the signal on lead (51), and where its counting direction is controlled (via lead (41)) as a function of the directional sense of the signal change to be inserted.

11. Circuit acc. to claim 7 and one or several of the following claims, characterized by a pulse mixer (3) consisting of a two-digit bidirectional Gray code counter (301 to 309) of which the counting flip-flops (301, 302) are linked to its updated output state, by the directional control signal (lead 43) via two EX-OR gates (303, 304) of which the outputs (leads 350, 351) are connected to the D inputs of the counting flip-flop (301 or 302) and which can be preset by the scanned and phase-adapted generator signals A″ and B″, via four NAND gates (305 to 308), on the supply of the presetting release by the control unit (4) via a lead (44), inhibiting at the same time, via a NOR gate (309), the release of the main scanning clock (lead 51) for clocking both counting flip-flops (301, 302).

12. Circuit acc. to claim 7 and one or serveral of the following claims, characterized by a decrementer (406) which is presettable by the number of additional signal changes (lead 49) and which receives the count release from a start flip-flop (401), triggered by the start command (lead 47), a NOR gate (405) and another flip-flop (402) if the release is not inhibited by any interrupt signal (lead 14) supplying at the same time the preset release for the pulse mixer (3) via a further flip-flop (403) and a lead (44), characterized moreover by a flip-flop (404), connected to the decrementer (406) and generating a stop signal (lead 452) on reaching the zero state, said flip-flop (404) resets the start flip-flop (401) thus terminating the current pulse mix-in sequence, and at the same time the sign memory, incorporated in the control unit (4) and comprising an inverter (407), two AND gates (408, 409) and two NOR gates (410, 411), controlled by the start flip-flop (401) (lead 453), is ready to receive the sign valid for the next pulse mix-in sequence and where the output (41) of the sign memory supplies the directional preselection for the phase inverter, thus determining at the same time the directional sense of the additional pulses to be inserted in the pulse mixer (3).

13. Circuit acc. to claim 8 and one or several of the following claims, characterized by a 4-phase clock generator (5) consisting of 4 D flip-flops (501 to 504) and being provided with a standard frequency generator (6) producing two pairs of balanced pulse trains Ø 1′ and Ø 2′ as well as Ø 1 and Ø 2 respectively which are in phase quadrature, phase-locked one to the other and distinguishing themselves pairwise by the factor 2 as fas as their frequency is concerned, and on this generator the clock phases Ø 1′ and Ø 2′ are available at the outputs of the flip-flops (501, 502) which are functioning as two-stage Gray code counters after having synchronously been clocked by the standard frequency generator (6) whilst the clock phases Ø 1 and Ø 2 are derived from the flip-flops (503, 504) which are also functioning as two-stage Gray code counters but which have asynchronously been clocked by the phases Ø 1′ and $\overline{Ø 1'}$, thus ensuring an unambiguous relationship between all four clocking phases.

## Revendications

1. Procédé de traitement des impulsions en quadrature dans des systèmes incrémentaux de mesure pour saisir les mouvements des éléments montés aux dispositifs mécaniques, déplaçables l'un vers l'autre et/ou tournant sur un seul ou sur plusieurs axes, particulièrement aux machines-outils, avec lequel les séries d'impulsions des générateurs incrémentaux sont, pour corriger des erreurs de positionnement et pour superposer d'une façon contrôlée des mouvements supplémentaires, balayées à une fréquence dépassant celle qui correspond à la vitesse de mouvement maximum, et avec lequel le résultat de la saisie de mouvement est modifiable par des impulsions supplémentaires et indépendantes du générateur, avec lequel, en outre, lors du balayage des séries d'impulsions A et B du générateur à un taux dépassant la fréquence de changement de niveau résultant d'une réunion logique exclusive, les pauses de changement d'impulsion qui sont disponibles à la sortie du dispositif de balayage au rythme de la différence entre les deux fréquences sont utilisées pour insérer des signaux supplémentaires indépendants du générateur, et avec lequel les pauses de changement d'impulsion sont saisies tant tôt qu'une insertion d'impulsion contrôlée et complète est initialisée qui comporte un changement de niveau de signal provoqué additionnellement avec l'une des deux séries d'impulsions de générateur à phase corrigée A′ et B′ qui viennent d'être balayées.

2. Procédé selon revendication 1, dûment caractérisé par ce que, grâce au pré-balayage des phases de générateur A′ et B′ par des impulsions à temps déplacé par rapport aux impulsions de balayage, lors d'un changement de niveau avec A′ ou B′, un signal d'interruption est généré tant tôt qu'un changement de niveau de signal supplémentaire, initialisé et prévu pour le prochain instant de balayage, est retenu avec l'une des phases de générateur A′ et B′, balayées et disponibles à la sortie du dispositif de balayage, aussi longtemps que celui-ci est inséré dans la prochaine pause de changement d'impulsion.

3. Procédé selon revendications 1 et 2, dûment caractérisé par ce que des changements de niveau de signal, initialisés additionnellement, avec chacune des phases de générateur A′ et B′, déjà balayées, sont provoqués par une attribution modifiée de ceux-ci d'un côté aux phases de signal A‴ et B‴, représentant le résultat de cette insertion d'impulsions et appliquées à un évaluateur subséquent, de l'autre côté, en fonction du sens de direction des impulsions supplémentaires et de l'attribution actuelle selon le schéma ci-après indiqué:

| A‴ → | A′ | B′ | $\overline{A'}$ | $\overline{B'}$ | A′ | B′ | $\overline{A'}$ | $\overline{B'}$ | A′ |
|---|---|---|---|---|---|---|---|---|---|
| B‴ → | B′ | $\overline{A'}$ | $\overline{B'}$ | A′ | B′ | $\overline{A'}$ | $\overline{B'}$ | A′ | B′ |

$\rightarrow$ $\rightarrow$ $\rightarrow$ $\rightarrow$ $\rightarrow$ $\rightarrow$ $\rightarrow$ $\rightarrow$ $\rightarrow$ $\rightarrow$ $\rightarrow$ $\rightarrow$ $\rightarrow$ $\rightarrow$,

et lors de cette insertion d'impulsions, un changement de signal en ce schéma vers la droite signifie une insertion à gauche et vice versa:

$\leftarrow$ $\leftarrow$ $\leftarrow$ $\leftarrow$ $\leftarrow$ $\leftarrow$ $\leftarrow$ $\leftarrow$ $\leftarrow$ $\leftarrow$ $\leftarrow$ $\leftarrow$ $\leftarrow$ $\leftarrow$

4. Procédé selon l'une des revendications 1 à 3, dûment caractérisé par ce que les changements de signaux d'entrée du dispositif de balayage $0 \rightarrow 1$ ou $1 \rightarrow 0$, la durée desquels est plus courte que celle des changements de signaux utiles contenant l'information, sont supprimés par la mesure de leur longueur sur deux phases horloge à temps déplacé en un montage de logique séquentiel, tout en les supprimant ou transférant en fonction du résultat de mesure.

5. Procédé selon revendication 4, dûment caractérisé par deux flip-flop D dont les signaux de sortie $\bar{Q}$ sont appliqués, par une réunion logique exclusive, à l'entrée D de l'un des deux flip-flop qui vient d'être déclenché par l'une des phases horloge et dont le signal de sortie $\bar{Q}$ est amené en même temps, par une autre réunion logique exclusive et avec le signal d'entrée, à l'entrée de remise à zéro de l'autre des deux flip-flop déclenché par la deuxième phase horloge, l'entrée D duquel est alimentée d'un niveau élevé stationnaire, la sortie $\bar{Q}$ du flip-flop mentionné le premier représentant le signal de sortie.

6. Procédé selon revendication 4, dûment caractérisé par ce que les changements d'impulsions de générateur A et B sont balayés pour les synchroniser avec l'impulsion de référence Z et encore par ce que les impulsions servant au pré-balayage de Z sont, par rapport à celles des phases de générateur A et B, légèrement décalées en retard pour assurer la saisie à temps de l'impulsion de référence Z, en cas de son retard par rapport aux changements d'impulsions de générateur A et B, attribuable au générateur, ainsi que pour appliquer celle-ci, parfaitement synchronisée avec l'impulsion de balayage principal, à la sortie du dispositif de balayage.

7. Circuit permettant de réaliser le procédé selon les revendications 1 à 3 comportant un dispositif de balayage à deux étages (1) pour les séries d'impulsions de générateur A, B et Z, et après ce dernier, un inverseur de phases (2) pour échanger et/ou inverser logiquement les impulsions de générateur A' et B' qui viennent d'être balayées, et auquel est relié, par les liaisons (21, 22), un mélangeur d'impulsions (3) pour insérer des impulsions extérieures et, en outre, une unité de commande (4) et un générateur horloge (5) avec étalon de fréquence (6) pour commander et coordiner les séquences de fonctionnement, et ce dernier étant relié au dispositif de balayage (1), à l'inverseur de phases (2), au mélangeur d'impulsions (3) et à l'unité de commande (4) pour l'alimentation horloge, et avec ce circuit l'unité de commande (4) sert à traiter les commandes d'entrée (47, 48, 49) et à initialiser leur exécution dans l'inverseur de phases (2), connecté à ladite unité de commande, et dans le mélangeur d'impulsions (3) qui, en tant que résultat du mélange d'impulsions, transfère les impulsions quad A''' et B''' à l'évaluateur alimenté de l'impulsion de référence Z.

8. Circuit selon revendication 7, dûment caractérisé par un étage d'entrée (ES) comportant un premier groupe (I) de chaque fois deux flipflop (101, 102 et 103, 104 resp.) pour canal A et canal B et de deux portes OU exclusif chacun (120, 121 et 122, 123 resp.), un étage de pré-balayage (VA) ayant un deuxième groupe (II) de cinq flipflop D (105 à 109) et trois portes OU exclusif (124 à 126) ainsi qu'un étage principal de balayage (HA) ayant un troisième groupe (III) de trois flipflop D (110 à 112), et encore caractérisé par l'étage d'entrée (ES) formant deux étages équilibrés supprimant des bruits $0 \rightarrow 1$ et $1 \rightarrow 0$, et avec ces étages, les sorties Q des flipflop D (102, 104) sont reliées par des conducteurs (143, 144) et des portes OU exclusif (121, 123) aux entrées D des flipflop D (102, 104), déclenchés selon les phases horloge, dont les sorties, enchaînées simultanément avec les entrées A et B par les portes OU exclusif (120, 122), sont connectées par des conducteurs (143, 144) aux entrées R des flipflop D (101, 103) qui viennent d'être déclenchés à temps déplacé et aux entrées D desquels est appliqué le niveau élevé stationnaire, et avec ce circuit les sorties (141, 142) de l'étage d'entrée (ES) sont reliées aux entrées de l'étage de pré-balayage (VA), et les sorties des flipflop D (102, 104) sont encore enchaînées par des conducteurs (143, 144) et une porte OU exclusif (125) à l'entrée de remise à zéro du flipflop (105) dont la sortie (145) déclenche les trois flipflop (107 à 109), appartenant à l'étage de pré-balayage, dont les sorties (148, 149) fournissent les signaux d'entrée pour les deux flipflop (111, 112) faisant partie de l'étage de balayage principal (HA) et étant déclenché par la sortie du flipflop (110), déclenché lui-même par l'horloge de balayage principal, et avec lequel la sortie (14) de l'étage de balayage principal (HA) représente le signal d'interruption.

9. Circuit selon revendication 8, pour le traitement de l'impulsion de référence, dûment caractérisé par un étage d'entrée (ET) comportant un quatrième groupe (IV) de deux flipflop (113, 114) prévus pour le canal Z, avec deux portes OU exclusif (127, 128), un étage de pré-balayage (VAS) comportant un cinquième groupe (V) de quatre flipflop D supplémentaires (115 à 118) ainsi que deux portes OU exclusif (129, 130) et un étage de balayage principal (HAS) ayant un flipflop (119) dont l'étage d'entrée (ET) forme un étage équilibré qui supprime les bruits $0 \rightarrow 1$ et $1 \rightarrow 0$, avec lequel les sorties $\bar{Q}$ (150, 157) sont enchaînées par une porte OU exclusif (128) et reliées à l'entrée du flipflop (114) dont la sortie $\bar{Q}$ est encore enchaînée par une porte OU exclusif (127) à l'entrée Z et connectée à l'entrée R du flipflop (113) dont l'entrée D reçoit le niveau élevé stationnaire, et avec lequel les deux flipflop (113, 114) sont déclenchés par des signaux horloge à temps déplacé et dont la sortie est reliée, par un conducteur (151), à l'étage de pré-balayage (VAS), d'un côté par l'une des portes OU exclusif (129) à l'entrée R de l'un des flipflop (115) et de l'autre côté à l'entrée D du deuxième flipflop (118) qui vient d'être déclenché, ensemble avec un flipflop (117), par le signal de sortie $\overline{Q}$ du flipflop (115) passant par un conducteur (152), et par cela l'entrée D dudit flipflop (115) se trouve par un conducteur (153), mise à niveau bas tant que le flipflop (119) de l'étage de balayage principal (HAS), à l'entrée D duquel est appliqué le signal de sortie de l'étage de pré-balayage (VAS) par un conducteur (154), est déclenché par le signal de sortie du flipflop (110) passant par un conducteur (155), simultanément avec l'apparition de l'impulsion de balayage principal, et par cela l'impulsion Z balayée s'applique à la sortie Q dudit flipflop (119) et s'amène par un conducteur (13) au circuit d'évaluation subséquent.

10. Circuit selon revendication 7, dûment caractérisé par un sélecteur de données (201 à 207) avec deux portes OU exclusif subséquentes (209, 210) fonctionnant comme inverseur commandé et un compteur-décompteur de commande à deux bit (211) fonctionnant en liaison avec une autre porte OU exclusif (208), et les entrées de cette dernière porte (208) qui commande l'une de ces portes OU exclusif (209), représentant les sorties de compteur Q1 (224) et Q2 (223), et avec lequel l'entrée de commande de la deuxième porte OU exclusif (210) est reliée par un conducteur (221) à la sortie Q2 du compteur (211), et avec lequel, en outre, la sortie de compteur Q1 est connectée aux entrées du sélecteur de données (201 à 207) par des conducteurs supplémentaires (225, 225a) et un inverseur (201) est inséré dans l'un des conducteurs (225), et avec lequel, en fonction du sens d'opération du compteur de commande (211), la relation entre les sorties A'' et B'' d'un côté et les entrées A' et B' de l'autre côté s'indique dans le schéma suivant:

$$A'' \rightarrow \quad A' \quad B' \quad \overline{A'} \quad \overline{B'} \quad A' \quad B' \quad \overline{A'} \quad \overline{B'} \quad A'$$
$$B'' \rightarrow \quad B' \quad \overline{A'} \quad \overline{B'} \quad A' \quad B' \quad \overline{A'} \quad \overline{B'} \quad A' \quad B',$$

avec lequel un changement d'attribution de signaux vers la droite signifie une insertion à gauche et vice versa, et avec ce sélecteur, le compteur (211) est libéré par un conducteur (42), en cas d'insertion d'un changement de signaux supplémentaire dans l'une des phases de générateur, pour le cadencer par le signal horloge sur un conducteur (51), et sa direction de comptage est commandée par un conducteur (41) en fonction du sens directionnel du changement de signaux à insérer.

11. Circuit selon revendication 7 et une ou plusieurs des revendications suivantes, dûment caractérisé par un mélangeur d'impulsions (3) comportant un compteur-décompteur de code réfléchi à deux bit (301 à 309) dont les flipflop de comptage (301, 302) sont enchaînés avec l'état de sortie actuel de ce mélangeur par le signal de commande directionnelle (conducteur 43) et deux portes OU exclusif (303, 304) dont les sorties (conducteurs 350, 351) sont reliées aux entrées D respectives des flipflop de comptage (301 ou 302), et les sorties de ces flipflop de comptage peuvent être prédéterminées par quatre portes PAS ET (305 à 308) moyennant les signaux de générateur à phase égalisée A'' et B'' qui viennent d'être balayés, lorsque l'unité de commande (4) libère la prédétermination par un conducteur (44) tout en arrêtant par une porte NI (309), la libération de la cadence principale (conducteur 51) pour cadencer les deux flipflop de comptage (301, 302).

12. Circuit selon revendication 7 et une ou plusieurs des revendications suivantes, dûment caractérisé par un décrémenteur (406), prédéterminable par le nombre de changements de signaux supplémentaires à insérer (conducteur 49) et libéré par un flipflop de démarrage (401) qui vient d'être déclenché par une commande de démarrage (conducteur 47), une porte NI (405) et un autre flipflop (402) si aucun signal d'interruption (conducteur 14) n'arrête la libération et libère en même temps, par un autre flipflop (403) et un conducteur (44), la prédétermination pour le mélangeur d'impulsions (3), et encore caractérisé par un flipflop (404), relié au décrémenteur (406), qui génère une impulsion d'arrêt (conducteur 452) à l'état zéro et remet le flipflop de démarrage (401) à zéro tout en terminant la séquence actuelle de mélange d'impulsions, et en même temps, la mémoire de signe qui est incorporée dans l'unité de commande (4) et contrôlée par le flipflop de démarrage (401) (conducteur 453), comportant un inverseur (407), deux portes ET (408, 409) et deux portes NI (410, 411), est prête à recevoir le signe valable pour la prochaine séquence de mélange d'impulsions, et la sortie (41) de la mémoire de signe prédétermine la direction de l'inverseur de phase tout en fixant le sens directionnel y appartenant pour les impulsions supplémentaires à insérer dans le mélangeur d'impulsions (3).

13. Circuit selon revendication 8 et une ou plusieurs des revendications suivantes, dûment caractérisé par un générateur horloge à quatre phases (5) comportant quatre flipflop D (501 à 504) et un générateur de fréquence standard (6) produisant deux paires de séries d'impulsions à phase en quadrature et équilibrées, Ø 1' et Ø 2' respectivement Ø 1 et Ø 2, qui se distinguent en leur fréquence, par couple, par le facteur 2 et qui ont été couplées à phase rigide l'une à l'autre, et avec lequel les phases horloge Ø 1' et Ø 2' s'appliquent aux sorties des flipflop (501, 502) fonctionnant comme compteurs de code réfléchi à deux étages et synchroniquement cadencés par le générateur de fréquence standard (6), tandis que les phases horloge Ø 1 et Ø 2 se dérivent des flipflop (503, 504), de même fonctionnant comme compteurs de code réfléchi à deux étages mais asynchroniquement cadencés par les phases Ø 1' et $\overline{Ø\ 1'}$, de sorte qu'une relation nettement définie est assurée entre toutes les quatre phases horloge.

Fig. 1

EP 0 155 974 B1

T₁        T₂        T₃        T₄

Fig. 2a

Fig. 2b

Fig. 2c

Fig. 2d

Fig. 2

EP 0 155 974 B1

501

D  S  Q ———→ φ1'

>

R  Q̄ ———→ φ̄1'

6

D  S  Q ———→ φ2'

>

R  Q̄ ———→ φ̄2'

502

503

D  S  Q ———→ φ1

>

R  Q̄ ———→ φ̄1

Fig. 3

D  S  Q ———→ φ2

>

504  R  Q̄ ———→ φ̄2

Fig. 4

Fig. 5

EP 0 155 974 B1

Fig. 6

Fig. 7

EP 0 155 974 B1